# EUROPEAN PATENT APPLICATION

(11) **EP 4 711 418 A1**
(43) Date of publication of application: **18.03.2026**
(21) Application number: 24806953.6
(22) Date of filing: 17.04.2024
(51) Int. Cl.: C08L 83/04, B29C 45/03, B29C 45/14, C08J 3/20, C08K 3/013, C08L 23/00, H01L 21/56, H01L 23/29, H01L 23/31

(54) **CURABLE SILICONE COMPOSITION, CURED OBJECT FORMED FROM SAME, AND METHOD FOR PRODUCING SAME**

(30) Priority: 12.05.2023 JP 2023079336
(71) Applicant: Dow Toray Co., Ltd., Tokyo 140-8617 (JP)
(72) Inventor: YAMAZAKI, Ryosuke, Ichihara-shi Chiba 299-0108 (JP)
(74) Representative: Elkington and Fife LLP
(86) International application number: PCT/JP2024/015276
(87) International publication number: WO 2024/236999

(57) **Abstract**

PROBLEM

To provide a curable silicone composition that can contain large amounts of functional inorganic filler and that gives a cured product characterized by high fluidity at high temperatures, with excellent hot-melt properties, gap filling properties, and uniformity, the cured product thereof having favorable mold removability, being suitable for use in molding or sealing processes such as transfer molding, generating little dust, and being easy to handle; and a method for producing the composition that offers excellent production efficiency and uniformity.

SOLUTION

A hot-melt curable silicone composition containing (A) a thermosetting silicone, (B) a functional inorganic filler, and (C) a polyolefin wax having a melting point of 130°C or lower and a viscosity at 140°C of 100 mPas or higher, and preferably also containing (D) a wax having a melting point of 130°C or lower and a viscosity at 140°C of less than 100 mPas, as well as uses thereof.

## Description

### TECHNICAL FIELD

The present invention relates to a curable silicone composition that has hot-melt properties, high fluidity and gap-filling properties at high temperatures, excellent mold removability during molding processes, and provides a cured product that exhibits strong adhesion to substrates. The present invention further relates to a cured product containing the curable silicone composition, a method for molding the cured product, and applications such as semiconductor devices and the like provided with the cured product. Note that in the present invention, the property of being solid at 25°C but showing viscosity at 180°C is referred to as "hot-melt property".

### BACKGROUND ART

Curable silicone compositions are utilized in a wide range of industrial fields because they are cured to form cured products having excellent heat resistance, cold resistance, electrical insulation, weather resistance, water repellency, and transparency. In general, the cured product of such a curable silicone composition is also suitable as a sealing agent for optical materials and semiconductor devices because discoloration is less likely to occur as compared with other organic materials and there is less deterioration of physical properties. In contrast, in recent years, hot-melt curable silicone compositions have been widely used as sealing agents for optical materials and semiconductor devices.

In Patent Documents 1 and 2, the patent applicant has proposed a granular hot-melt curable silicone composition for molding, the main component of which is a resinous silicone that can be used for the applications described above. When made into pellet or tablet form, the composition can be used in a transfer molding process. However, when this composition is used in transfer molding, there is a problem that removal from the mold after molding may be difficult, depending on the shape of the mold.

A commonly known method for improving the mold removability during molding is to add a small amount of a wax component to the composition, and Patent Documents 1 to 4 describe that a general wax may be added. However, depending on the type and amount of wax added, these wax components can improve the mold removability during molding, but at the same time, there is also an effect of causing a loss of adhesive strength in the cured product. Therefore, the type and amount of wax to be added must be optimized, but the aforementioned documents do not disclose this information. Patent Document 5 describes that "plasticizers, non-reactive waxes, reactive waxes, tackifier resins, and combinations thereof" may be added to a moisture-curable hot-melt silicone adhesive composition as an optional component (a rheology aid for improving melt viscosity, and the like). However, there is no mention or suggestion of using a specific wax in combination with a thermosetting silicone, or of a composition that can incorporate a large amount of functional inorganic filler. Furthermore, because the composition is moisture-curable, the speed of the curing system and the mechanical strength of the cured product may be insufficient. In addition, Patent Document 5 does not describe or suggest anything about fast-curing thermosetting silicones that contain a specific branched silicone as a base component, a specific wax or combination thereof, or a large amount of a functional filler.

### RELATED ART DOCUMENTS

### PATENT DOCUMENTS

Patent Document 1: International Patent Application Publication 2018/030288
Patent Document 2: International Patent Application Publication 2018/235491
Patent Document 3: International Patent Application Publication 2018/235492
Patent Document 4: Japanese Patent No. 4964928
Patent Document 5: Japanese Unexamined Patent Application Publication 2016-514172

### SUMMARY OF THE INVENTION

### PROBLEM TO BE SOLVED BY THE INVENTION

An object of the present invention is to provide: a curable silicone composition that can contain a large amount of a functional inorganic filler, provides a cured product with excellent hot-melt, gap-filling, and homogeneity properties characterized by high fluidity at high temperatures, and provides a cured product that expresses strong adhesive strength, is suitable for transfer molding, compression molding, press molding, and other molding or sealing processes, and has excellent mold removability during molding; and a manufacturing method with excellent production efficiency and homogeneity. Furthermore, the present invention provides: a cured product obtained by curing the curable silicone composition; a member for a semiconductor device including the cured product; a semiconductor device having the cured product; and a method for molding a cured product.

### MEANS FOR SOLVING THE PROBLEM

As a result of extensive research the present inventors discovered that the aforementioned object can be achieved by a curable silicone composition, containing: (A) a thermosetting silicone; (B) a functional inorganic filler; and (C) a polyolefin wax having a melting point of 130°C or less and a viscosity at 140°C of 100 mPas or more, wherein the amount of component (B) is 40 parts by mass or more per 100 parts by mass of component (A), and the composition as a whole exhibits hot-melt properties. Thereby the present invention was achieved.

Furthermore, the composition may include a wax with a melting point of 130°C or lower and a viscosity at 140°C of less than 100 mPas, and component (A) may be a thermosetting silicone containing at least:
(A1) an organopolysiloxane resin containing at least 20 mol% or more of siloxane units expressed by RSiO_{3/2} (where R represents a monovalent hydrocarbon group) with respect to all siloxane units; and
(A2) a curing agent.

The composition may be compositionally homogenized by melt kneading in a temperature range of 50 to 150°C, and then molded into a granular form. Furthermore, the composition of the present invention may be further compressed into pellets or tablets (particularly including tableting).

The aforementioned problem is solved by a cured product of the curable silicone composition, use as a member for semiconductor devices, and a method for molding the cured product.

### EFFECT OF THE INVENTION

The present invention can provide a curable silicone composition that contains a high amount of functional inorganic filler and exhibits high fluidity at high temperature, and therefore has excellent hot-melt properties, gap-filling properties, and uniformity, and forms a cured product that adheres firmly to a substrate. By possessing these properties, the curable silicone composition is suitable for use in molding and sealing processes such as transfer molding, compression molding, and press molding, and because excellent mold removability is exhibited during molding, a method for producing cured products can be provided with excellent production efficiency and uniformity. Furthermore, the present invention can provide: a cured product obtained by curing the curable silicone composition; a member for a semiconductor device including the cured product; a semiconductor device having the cured product; and a method for molding a cured product.

### DESCRIPTION OF THE PREFERRED EMBODIMENTS

### [Curable Silicone Composition]

The curable silicone composition of the present invention has the following compositional characteristics, and as a result, the composition as a whole has hot-melt properties. The composition is solid at room temperature, but from the viewpoint of handling and moldability, the composition may be granular, which may then be, and is preferably, compressed and molded into a pellet-shaped molded product or tablet-shaped molded product.

The curable silicone composition of the present invention contains: (A) a thermosetting silicone; (B) a functional inorganic filler; and (C) a polyolefin wax having a melting point of 130°C or less and a viscosity at 140°C of 100 mPas or more, wherein the amount of component (B) is 40 parts by mass or more per 100 parts by mass of component (A), and the composition as a whole compositionally exhibits hot-melt properties, but may also contain component (D) described below and other optional components as necessary.

### [Component (A)]

Component (A) is the main component of the composition and is a silicone component that exhibits thermosetting properties. Component A may be a single component or a mixture of several components, so long as thermosetting properties are exhibited. Furthermore, the thermosetting functional group may be of one type or of two or more types.

Component (A) is preferably a curable reactive functional group, and examples include hydrosilylation reactive groups and radical reactive groups. Examples of the hydrosilylation reactive group include vinyl groups, allyl groups, butenyl groups, pentenyl groups, hexenyl groups, heptenyl groups, octenyl groups, nonenyl groups, decenyl groups, undecenyl groups, dodecenyl groups, and other alkenyl groups having 2 to 20 carbon atoms, and silicon atom-bonded hydrogen atoms. An alkenyl group is preferable as the hydrosilylation reactive group. The alkenyl group may be linear or branched and is preferably a vinyl group or a hexenyl group. Component (A) preferably has at least two hydrosilylation reactive groups in one molecule.

Examples of groups bonded to a silicon atom other than the hydrosilylation reactive group in component (A) include methyl groups and other alkyl groups having 1 to 20 carbon atoms, halogen-substituted alkyl groups having 1 to 20 carbon atoms, phenyl groups and other aryl groups having 6 to 20 carbon atoms, halogen-substituted aryl groups having 6 to 20 carbon atoms, aralkyl groups having 7 to 20 carbon atoms, alkoxy groups, and hydroxyl groups. Methyl groups, phenyl groups, and hydroxyl groups are particularly preferable.

Furthermore, examples of radical reactive groups in component (A) include: methyl groups and other alkyl groups having 1 to 20 carbon atoms; vinyl groups, hexenyl groups, and other alkenyl groups having 2 to 20 carbon atoms; 3-acryloxypropyl groups, 4-acryloxybutyl groups, and other acrylic-containing groups; 3-methacryloxypropyl groups, 4-methacryloxybutyl groups, and other methacrylic-containing groups; and silicon atom-bonded hydrogen atoms. An alkenyl group is preferable as the radical reactive group. The alkenyl group may be linear or branched and is preferably a vinyl group or a hexenyl group. Component (A) preferably has at least two radical reactive groups in one molecule.

Examples of the group bonded to a silicon atom other than the radical reactive group in component (A) include halogen-substituted alkyl groups having 1 to 20 carbon atoms, aryl groups having 6 to 20 carbon atoms, halogen-substituted aryl groups having 6 to 20 carbon atoms, aralkyl groups having 7 to 20 carbon atoms, alkoxy groups, and hydroxyl groups, with the same groups as those described above being exemplified. In particular, a phenyl group and a hydroxyl group are preferable. In particular, in component (A), 10 mol% or more of all organic groups in a molecule is preferably an aryl group, and particularly preferably a phenyl group.

From the viewpoint of imparting practical hot-melt properties and thermosetting properties to the present composition, wherein component (A) contains at least: (A1) an organopolysiloxane resin containing at least 20 mol% or more of siloxane units expressed by RSiO_{3/2} (where R represents a monovalent hydrocarbon group) with respect to all siloxane units; and (A2) a curing agent.

### [Component (A1)]

Component (A1) is an organopolysiloxane resin containing siloxane units expressed by RSiO_{3/2} (where R is a monovalent hydrocarbon group) (hereinafter, sometimes simply referred to as "T units") in an amount of at least 20 mol% of all siloxane units, and has the aforementioned thermosetting reactive functional group within the molecule. From the viewpoint of the curing rate of the resulting composition, the thermosetting reactive functional group in component (A1) preferably undergoes either a hydrosilylation reaction or a radical reaction, or both. Furthermore, component (A1) is preferably an organopolysiloxane resin component that has a softening point of 30°C or higher and that itself has hot-melt properties.

### [Component (A1-1)]

Component (A1) is (A1-1) a hot-melt organopolysiloxane resin having a softening point of 30°C or higher and containing a carbon-carbon double bond (hydrosilylation reactive group and/or radical reactive group) in the molecule, and preferably contains siloxane units expressed by RSiO_{3/2} (wherein R is a monovalent hydrocarbon group) in an amount of at least 20 mol% of all siloxane units. Furthermore, component (A1) is preferably (A1-1-1) a hot-melt organopolysiloxane resin in which at least 10 mol% of the silicon-bonded organic groups are aryl groups.

Examples of such component (A1-1) suitably include MT resins, MDT resins, MTQ resins, MDTQ resins, TD resins, TQ resins, and TDQ resins, which include an arbitrary combination of triorganosiloxy units (M unit) (organo groups are methyl groups only, methyl groups and the aforementioned curable reactive groups or phenyl groups), diorganosiloxy units (D units) (organo groups are methyl groups only, methyl groups and the aforementioned curable reactive functional groups or phenyl groups), monoorganosiloxy units (T units) (organo groups are methyl groups, the aforementioned curable reactive groups, or phenyl groups), and siloxy units (Q units) and in which the amount of T units is at least 20 mol% or more of all siloxane units. Note that component (A1) preferably has a curable reactive functional group containing at least two carbon-carbon double bonds (hydrosilylation reactive groups and/or radical reactive groups) in a molecule, and 10 mol% or more of all the silicon atom-bonded organic groups in a molecule are aryl groups, and particularly phenyl groups.

Preferably, component (A1-1) includes an organopolysiloxane having hot-melt properties that is solid at room temperature but softens as the temperature increases, as expressed by the following:

(R¹₃SiO_{1/2})ₐ(R²₂SiO_{2/2})_{b}(R³SiO_{3/2})_{c}(SiO_{4/2})_{d}(R⁴O_{1/2})ₑ.

In the formula, R¹, R², and R³ are each independently a monovalent hydrocarbon group having 1 to 10 carbon atoms, provided that at least two of all R groups in one molecule must be the aforementioned curable reactive functional groups, and 70 mol% or more of all curable reactive functional groups are preferably in R¹. R⁴ represents a hydrogen atom or an alkyl group having 1 to 10 carbon atoms; "a", "b", "c", "d", and "e" are numbers satisfying the following. (0.10 ≤ a ≤ 0.40, 0 ≤ b ≤ 0.50, 0.20 ≤ c ≤ 0.90, 0 ≤ d ≤ 0.20, 0 ≤ e ≤ 0.05, but a + b + c + d = 1)

Note that a preferred alkenyl group amount is 10 to 20 mol% of all R components. This is because if the amount of curable reactive function groups is less than or equal to this range, a cured product exhibiting sufficient strength cannot be obtained, and if the amount is greater than or equal to this range, the cured product tends to be hard and brittle. The curable reactive functional group is preferably an alkenyl group, and examples thereof include vinyl groups, allyl groups, butenyl groups, pentenyl groups, and hexenyl groups. Furthermore, at least some of R¹, R², and R³ are preferably aryl groups, and more preferably phenyl groups, from the perspective of imparting suitable hot-melt properties to the present component. Other examples of monovalent hydrocarbon groups can include methyl groups and the like.

Furthermore, in the formula, "a" represents a number indicating the ratio of siloxane units expressed by the general formula: R¹₃SiO_{1/2}, and is a number satisfying 0.10 ≤ a ≤ 0.40, and preferably 0.10 ≤ a ≤ 0.30. This is because when the value of "a" is less than or equal to the upper limit of the aforementioned range, the hardness of the obtained cured product at room temperature is favorable. On the other hand, when the value of "a" is greater than or equal to the lower limit of the lower limit range, favorable hot-melt properties are achieved. Furthermore, in the formula, "b" represents a number indicating the ratio of siloxane units expressed by the general formula: R²₂SiO_{2/2}, and is a number satisfying 0 ≤ b ≤ 0.5. This is because when the value of "b" is less than or equal to the upper limit of the aforementioned range, favorable hot-melt properties can be achieved. Furthermore, in the formula, "c" represents a number indicating the ratio of siloxane units expressed by the general formula: R³SiO_{3/2}, and is a number satisfying 0.20 ≤ c ≤ 0.90, and preferably 0.25 ≤ c ≤ 0.85. This is because when the value of "c" is greater than or equal to the lower limit of the aforementioned range, the hardness of the obtained cured product at room temperature is favorable. On the other hand, when the value of "c" is less than or equal to the upper limit of the aforementioned range, mechanical strength of the obtained cured product is favorable. Furthermore, in the formula, "d" represents a number indicating the ratio of siloxane units expressed by the general formula: SiO_{4/2}, and is a number satisfying 0 ≤ d ≤ 0.20, and preferably 0 ≤ d ≤ 0.10. This is because when the value of "d" is less than or equal to the upper limit of the aforementioned range, the mechanical strength of the obtained cured product is favorable. Furthermore, "e" represents a number indicating the ratio of units expressed by the general formula: R²O_{1/2}, and is a number satisfying 0 ≤ e ≤ 0.05. This is because when the value of "e" is less than or equal to the aforementioned upper limit, the hardness of the obtained cured product at room temperature is favorable. Note that the sum of "a", "b", "c", and "d" in the formula is 1.

Component (A1) preferably exhibits hot-melt properties and, specifically, is non-fluid at 25°C. The melt viscosity at 150°C is 8000 Pa·s or less, preferably 5000 Pa·s or less, and more preferably in the range of 10 to 3000 Pa·s. Non-fluid refers to not flowing in a no-load state, for example, the state of being less than the softening point measured by the softening point testing method in the ball and ring method of hot-melt adhesives specified in "Testing methods for the softening point of hot-melt adhesives" of JIS K 6863-1994. In other words, in order to be non-fluid at 25°C, the softening point must be higher than 25°C.

Component (A), preferably component (A1), and more preferably component (A1-1), may be any organosiloxane resin of any molecular weight so long as the aforementioned structure and melting properties are exhibited. For example, an organopolysiloxane with the aforementioned structure may be used, in which a portion of the curable reactive function groups and the like (alkenyl groups and the like) is cross-linked by component (A2) described later, to raise the molecular weight, but from the perspective of the melting properties of the resulting composition, the molecular weight (Mw) thereof is preferably 20,000 g/mol or less.

Furthermore, component (A1), preferably component (A1-1) is solid at room temperature as described above, and thus is preferably used as a resin in microparticle form or as a liquid mixture dissolved in another component required for the present composition from the perspective of ease of handling when mixed with other components.

If component (A1), preferably component (A1-1), is in the form of microparticles, the particle size is not limited, but the average primary particle size is preferably within the range of 1 to 5,000 µm, within the range of 1 to 500 µm, within the range of 1 to 100 µm, within the range of 1 to 20 µm, or within the range of 1 to 10 µm. The average primary particle size can be determined, for example, by observation with an optical microscope or an SEM. The shape of the microparticulate component (A1) is not limited, and examples include spherical shapes, spindle shapes, plate shapes, needle shapes, and irregular shapes, with a spherical shape or a true spherical shape being preferable for homogenous melting. In particular, by making component (A1) into true spherical microparticles, the process of producing the present composition by powder mixing or melt kneading, as described later, can be efficiently performed.

When component (A1) is microparticulated, the manufacturing method is not limited and a known method can be used. Note that when obtaining the microparticulate component (A1), a hydrosilylation reaction catalyst, which is component (A2) described later, may and is preferably microparticulated along with component (A1).

Specific examples of the method for microparticulating component (A1) include methods for pulverizing component (A1), which is solid at room temperature, using a pulverizer and methods for directly microparticulating component (A1) in the presence of a solvent. While not limited thereto, the pulverizer may be, for example, a roll mill, a ball mill, a jet mill, a turbo mill, or a planetary mill. Furthermore, component (A1) may also be directly microparticulated in the presence of a solvent, for example, by spraying with a spray dryer, or by a twin-shaft kneading machine or belt dryer. When component (A1) is microparticulated, true spherical hot-melt organopolysiloxane resin microparticles obtained by spraying with a spray dryer are preferably used.

Component (A1), having a regular spherical shape and an average primary particle size of 1 to 500 µm, can be manufactured by the use of a spray dryer or the like. Note that the heating and drying temperature of the spray dryer needs to be appropriately set based on the heat resistance and the like of the organopolysiloxane resin microparticles. Note that in order to prevent secondary aggregation of the organopolysiloxane resin microparticles, the temperature of the organopolysiloxane resin microparticles is preferably controlled below the glass transition temperature thereof. The organopolysiloxane resin microparticles thus obtained can be recovered by a cyclone, a bag filter, or the like.

In order to obtain a uniform component (A1), a solvent may be used in the abovementioned step within a range that does not inhibit the curing reaction. Examples of solvents include, but are not limited to: aliphatic hydrocarbons such as n-hexane, cyclohexane, n-heptane, and the like; aromatic hydrocarbons such as toluene, xylene, mesitylene, and the like; ethers such as tetrahydrofuran, dipropyl ether, and the like; silicones such as hexamethyldisiloxane, octamethyltrisiloxane, decamethyltetrasiloxane, and the like; esters such as ethyl acetate, butyl acetate, propylene glycol monomethyl ether, and the like; and ketones such as acetone, methyl ethyl ketone, methyl isobutyl ketone, and the like.

Furthermore, when a silicone compound that is liquid at room temperature is used as all or part of component (A2) described later, component (A1) may be dissolved in part of component (A2). Liquid silicone compounds exhibit a certain degree of mutual solubility with component (A1), and can dissolve component (A1) by adding, for example, 10 to 50 parts by mass of some of component (A2) to 100 parts by mass of component (A1). By liquefying component (A1), the present composition described later can be efficiently produced by powder mixing or melt kneading.

### [Component (A2)]

Component (A2) is a curing agent for curing component (A1) and is not limited so long as component (A1) can be cured. When component (A1) has a curable reactive function group having a carbon-carbon double bond such as an alkenyl group or the like, component (A2) is an organohydrogenpolysiloxane having at least two silicon atom-bonded hydrogen atoms in one molecule and a hydrosilylation reaction catalyst. Moreover, when component (A1) contains an alkenyl group and contains a hydrosilylation reaction catalyst, component (A2) may only be an organopolysiloxane having at least two silicon atom-bonded hydrogen atoms in one molecule. However, a hydrosilylation reaction catalyst may be used in combination. Furthermore, when component (A1) has an alkenyl group, component (A2) may be an organic peroxide, and an organopolysiloxane having at least two silicon atom-bonded hydrogen atoms may be used in combination in one molecule. On the other hand, when component (A1) contains a silicon-bonded hydrogen atom, component (A2) contains an organopolysiloxane having at least two curable reactive functional groups with carbon-carbon double bonds in each molecule, such as alkenyl groups, and a hydrosilylation catalyst. When component (A1) contains a silicon-bonded hydrogen atom and a hydrosilylation catalyst, component (A2) may contain only an organopolysiloxane having at least two curable reactive functional groups containing carbon-carbon double bonds such as alkenyl groups per molecule, although a hydrosilylation catalyst may also be used in combination. Furthermore, if component (A1) has a reactive silanol group, a condensation catalyst may be included. Note that when a condensation reaction is used as the curing reaction, a known thermal base generator or the like may be used as part of component (A2).

As described above, component (A2) contains a curing catalyst tailored to a selected reaction system, but the composition according to the present invention is preferably homogenized by melt kneading or the like in the temperature range of 50 to 150°C, and preferably 50 to 120°C, for the purpose of compositional homogenization. Therefore, from the perspective of inhibiting unintended curing reactions and maintaining the curing reactivity of the curable silicone composition according to the present invention, component (A2) is preferably a curing catalyst that is inactive unless subjected to a certain thermal energy stimulation. Specifically, component (A2) is particularly preferably a curing agent and contains a curing reaction catalyst that is active in the composition by thermal energy stimulation of 80°C or higher, preferably 100°C or higher, and more preferably 120°C or higher, and is a curing catalyst that does not initiate a curing reaction below these temperatures.

More specifically, component (A2) preferably contains one or more types of curing catalyst selected from: (A2-1) organic peroxides with a half-life of 10 hours at a temperature of 80°C or higher; and (A2-2) hydrosilylation reaction catalyst-containing thermoplastic resin microparticles containing a thermoplastic resin with a softening point or glass transition point of 80°C or higher, and preferably contains a combination thereof. This is because the use of components (A2-1) or (A2-2) as a portion of the curing agent effectively suppresses unintended curing reactions even when the composition is homogenized and granulated by a process involving heating such as melt kneading or the like, and thus the resulting granular composition has both favorable hot-melt properties and curing properties at high temperatures.

Component (A2-1) is a curing agent suitable for use when a radical reaction is used as the curing reaction in the present composition, and is preferably an organic peroxide with a half-life of 10 hours at a temperature of 90°C or higher or 95°C or higher. Examples of such organic peroxide include dicumyl peroxide, di-tert-butyl peroxide, di-tert-hexyl peroxide, tert-butylcumyl peroxide, 2,5-dimethyl-2,5-di(tert-butylperoxy)hexane, 1,3-bis(tert-butylperoxyisopropyl)benzene, di-(2-tert-butylperoxyisopropyl)benzene, and 3,6,9-triethyl-3,6,9-trimethyl-1,4,7-triperoxonan.

While not limited thereto, the amount of organic peroxide is preferably within the range of 0.05 to 10 parts by mass or within the range of 0.10 to 5.0 parts by mass, with respect to 100 parts by mass of component (A1).

Component (A2-2) is part of the curing agent suitably used when a hydrosilylation reaction is used as the curing reaction in the present composition, and may be either microparticles in which the platinum-based catalyst is dissolved or dispersed in the thermoplastic resin, or microcapsule microparticles with a structure in which the platinum-based catalyst is included as a core within a thermoplastic resin shell. Examples of the platinum-based catalyst include platinum black, platinum-supported carbon fine powders, platinum-supported silica fine powders, platinum chlorides, alcohol-modified platinum chlorides, platinum olefin complexes, and platinum alkenylsiloxane complexes. The thermoplastic resin used for component (A2-2) is not particularly limited so long as the platinum-based catalyst does not substantially permeate at least during production and storage of the present composition and is not substantially soluble in a main component organopolysiloxane of the present composition. However, the softening point or glass transition point of the thermoplastic resin is preferably 80°C or higher, and more preferably 120°C or higher. Specifically, silicone resin, polysilane resin, epoxy resin, acrylic resin, methylcellulose resin, and polycarbonate resin can be suitably used, but solubility in the present composition must be low. The softening point is the temperature at which a resin begins to flow under its own weight or by its own surface tension, and can be measured by a method of observing pulverized particles under a microscope while increasing the temperature at a constant rate. Furthermore, the glass transition point can be measured by a DSC (differential scanning calorimeter). In the present invention, either the softening point or the glass transition point is preferably 120°C or higher. This is because if the softening point or glass transition point of the thermoplastic resin is less than 120°C, there is a concern that the platinum component will begin to elute during the homogeneous mixing step of the present composition, which is described later. Furthermore, the average particle size of the thermoplastic fine particles containing the platinum-based catalyst is not limited, but is preferably in the range of 0.1 to 500 µm, and more preferably in the range of 0.3 to 100 µm. This is because preparing thermoplastic resin microparticles containing a platinum-based catalyst with an average particle size that is less than the lower limit of the range above is difficult. On the other hand, dispersibility in the curable silicone resin composition is reduced if the average particle size exceeds the upper limit of the range above.

The method for preparing the thermoplastic resin microparticles containing the platinum-based catalyst is not limited, and examples include conventionally known chemical methods such as interfacial polymerization, in-situ polymerization, and the like, and physical and mechanical methods such as coacervation, drying in liquid, and the like. The drying in liquid method and vapor phase drying method are particularly desirable because obtaining microcapsule fine particles with a narrow particle size distribution is relatively easy. The microparticles obtained by these methods can be used as is, but it is desirable to wash the microparticles with an appropriate cleaning solvent to remove the platinum-based catalyst attached to the surface, in order to obtain a curable silicone resin composition with excellent storage stability. Herein, an appropriate cleaning solvent does not dissolve the thermoplastic resin, but has a property of dissolving the platinum-based catalyst. Examples of such cleaning solvents include methyl alcohol, ethyl alcohol, and other alcohols, hexamethyldisiloxane and other low molecular weight organopolysiloxanes, and the like. The ratio of hydrosilylation reaction catalyst to thermoplastic resin is not particularly limited, because the value varies greatly depending on the method for manufacturing a granular product, but the ratio is preferably such that the amount of platinum-based catalyst to thermoplastic resin is 0.01 mass% or more. This is because if the amount of platinum-based catalyst is less than 0.01 mass%, the physical properties of the cured product of the present composition will be impaired unless a large amount of thermoplastic resin fine particles containing the platinum-based catalyst is included in the present composition.

The amount of the hydrosilylation reaction catalyst added is preferably an amount in which the metal atoms are within the range of 0.01 to 500 ppm, 0.01 to 100 ppm, or 0.01 to 50 ppm in mass units with respect to the entire composition.

When a hydrosilylation reaction is used as the curing reaction of the present composition, component (A2) may contain, in addition to the hydrosilylation reaction catalyst (preferably component (A2-2) described above), an organosiloxane component other than component (A1) as a hydrosilylation cross-linking component, and preferably contains (A2-3) an organohydrogenpolysiloxane. The structure thereof is not particularly limited and can be linear, branched, cyclic or resinous. However, from the perspective of excellent curing properties of the resulting composition, an organohydrogenpolysiloxane having a hydrogen diorganosiloxy unit expressed by HR₂SiO_{1/2} (M^{H} unit, where R independently represents a monovalent organic group) at an end is preferable.

The organohydrogenpolysiloxane serving as the hydrosilylation cross-linking component (A2-3) is more specifically preferably an organopolysiloxane in which 20 to 70 mol% of all silicon atom-bonded organic groups are phenyl groups. When the amount of phenyl groups is greater than or equal to the lower limit of the range above, the resulting cured product has favorable mechanical strength at high temperatures, while when the amount of phenyl groups is less than or equal to the upper limit of the range above, the resulting cured product has favorable mechanical strength.

Two or more silicon atom-bonded hydrogen atoms in component (A2-3) are present in one molecule, which provides sufficient cross-linking reactivity for curing and favorable hardness of the resulting cured product. Examples of the silicon atom-bonded organic groups in component (A2-3) include monovalent hydrocarbon groups having no unsaturated aliphatic bonds, such as: methyl groups, ethyl groups, propyl groups, butyl groups, pentyl groups, hexyl groups, heptyl groups, cyclopentyl groups, cyclohexyl groups, cycloheptyl groups, and other alkyl groups; phenyl groups, tolyl groups, xylyl groups, and other aryl groups; benzyl groups, phenethyl groups, and other aralkyl groups; and the like. Of these, phenyl groups and alkyl groups having 1 to 6 carbon atoms are preferred.

Two examples of component (A2-3) include:
(A2-3-1) a linear organopolysiloxane expressed by the general formula:

   HR⁴₂SiO(R⁴₂SiO)ₙSiR⁴₂H

   and
(A2-3-2) a branched organopolysiloxane expressed by the average unit formula:

   (R⁴SiO_{3/2})ₚ(R⁴₂SiO_{2/2})_{q}(HR⁴₂SiO_{1/2})ᵣ(SiO_{4/2})ₛ(XO_{1/2})ₜ.
A combination of these two components (A2-3) is preferably used as the hydrosilylation cross-linking component.

In the formulas, R⁴ represents the same or different phenyl groups or alkyl groups having 1 to 6 carbon atoms. Examples of alkyl groups of R⁴ include methyl groups, ethyl groups, propyl groups, butyl groups, pentyl groups, hexyl groups, cyclopentyl groups, and cyclohexyl groups. Note that of all R⁴s, the amount of phenyl groups is in the range of 30 to 70 mol%.

Furthermore, in the formula, "n" represents an integer in the range of 5 to 1,000. In the formula, "p" represents a positive number, "q" represents 0 or a positive number, "r" represents a positive number, "s" represents 0 or a positive number, and "t" represents 0 or a positive number. Moreover, "q"/"p" is a number in the range of 0 to 10, "r"/"p" is a number in the range of 0.1 to 5, "s"/("p"+"q"+"r"+"s") is a number in the range of 0 to 0.3, and "t"/("p"+"q"+"r"+"s") is a number in the range of 0 to 0.4.

In such component (A2-3), a combination of component A2-3-1) and component (A2-3-2) is preferable from the perspective of ease of control of the curing rate of the composition and the cross-linking density of the resulting cured product. A suitable ratio of the two components is in the range of (A2-3-1) : (A2-3-2) = 0.05 to 0.6 : 0.4 to 0.95 per alkenyl group of the entire composition, preferably in the range of 0.05 to 0.5 : 0.5 to 0.95, and more preferably in the range of 0.05 to 0.4 : 0.5 to 0.95.

When the organohydrogenpolysiloxane above is used as part of component (A2), the amount thereof is not limited. However, in order to cure the present composition, the amount is preferably in the range of 0.5 to 20 mols or 1.0 to 10 mols of silicon atom-bonded hydrogen atoms per mol of alkenyl groups in the present composition. Note that the amount of the hydrosilylation reaction catalyst used is as described above.

In the composition according to the present invention, a particularly preferable component (A2) contains component (A2-2), component (A2-3-1), and component (A2-3-2) described above, and the composition as a whole effectively suppresses side reactions and unintended curing reactions, and has the advantage of excellent hot-melt and heat curing properties at high temperatures.

### [Component (B)]

Component (B) of the present invention is a functional inorganic filler that can provide a cured product with functionality that depends on the type of inorganic filler, and can provide a curable silicone composition which upon curing provides a cured product with excellent hardness and toughness from room temperature to high temperature. The present invention can provide the aforementioned properties by adding 40 parts by mass or more of component (B) per 100 parts by mass of component (A). If a harder and tougher cured product is desired, the amount can be within a range of 100 to 3000 parts by mass, 500 to 3000 parts by mass, or 800 to 3000 parts by mass. By selecting component (A), a low melt viscosity suitable for encapsulation, transfer molding, compression molding, and press molding can be provided, even when a large amount of component (B) is added.

From the perspective of achieving a low average linear expansion coefficient with respect to the cured product of the curable silicone composition according to the present invention, the amount of component (B) is preferably 50 vol.% or more of the total composition, more preferably 60 vol.% or more, even more preferably 70 vol.% or more, and particularly preferably in the range of 80 to 95 vol.%.

In order to achieve the blending amount above and to achieve a low average linear expansion coefficient for the resulting cured product, component (B) is preferably treated with a specific surface treating agent (Component B'), and particularly Component (B') in an amount of 0.1 to 2.0 mass%, 0.1 to 1.0 mass%, or 0.2 to 0.8 mass% of the total mass of component (B). By treating component (B) with Component (B') in the amount described above, there is an advantage that component (B) can be stably compounded in the composition at a high vol.%. In addition, the surface treatment method is optional, with a desired method such as a uniform mixing method using mechanical force (dry), a wet mixing method using a solvent, or the like capable of being used.

Examples of Component (B') include methylhydrogenpolysiloxane, silicone resins, metal soaps, silane coupling agents, perfluoroalkylsilane, perfluoroalkylphosphate ester salts, and other fluorine compounds, and the like. However, silicone-based surface treating agents described below are particularly preferable. Note that if a silane-based surface treating agent, such as methyltrimethoxysilane, phenyltrimethoxysilane, or the like, is selected as component (B'), the hot-melt properties of the entire composition may be impaired, and stable blending of component (B) at the vol.% amount described above may not be feasible. Furthermore, when an alkyltrialkoxysilane having a long-chain alkyl group such as an octyl group is selected as a surface treatment agent, it tends to be possible to maintain the hot-melt properties of the composition and the compounding stability of component (B); however, the strength of the cured product obtained by curing the composition of the present invention may be negatively affected, which may cause cracking or molding defects.

Herein, examples of organic silicon compounds as component (B') include silanes, silazanes, siloxanes, and other low molecular weight organic silicon compounds, along with organic silicon polymers or oligomers such as polysiloxanes, polycarbosiloxanes, and the like. A so-called silane coupling agent is an example of a preferred silane. Typical examples of the silane coupling agents include alkyltrialkoxysilanes (such as methyltrimethoxysilane, vinyltrimethoxysilane, hexyltrimethoxysilane, octyltrimethoxysilane, decyltrimethoxysilane, and the like) and trialkoxysilanes containing an organic functional group (such as glycidoxypropyltrimethoxysilane, epoxycyclohexyl ethyltrimethoxysilane, methacryloxypropyltrimethoxysilane, aminopropyltrimethoxysilane, and the like). Examples of preferred siloxanes and polysiloxanes include hexamethyldisiloxanes, 1,3-dihexyl-tetramethyldisiloxanes, trialkoxysilyl single-terminated polydimethylsiloxanes, trialkoxysilyl single-terminated dimethylvinyl single-terminated polydimethylsiloxanes, trialkoxysilyl single-terminated organic functional group single-terminated polydimethylsiloxanes, trialkoxysilyl doubly-terminated polydimethylsiloxanes, organic functional group doubly-terminated polydimethylsiloxanes, and the like. When a siloxane is used, the number "n" of siloxane bonds is preferably within the range of 2 to 150. Examples of preferred silazanes include hexamethyldisilazanes, 1,3-dihexyl-tetramethyldisilazanes, and the like. A polymer having a Si-C-C-Si bond in a polymer main chain is an example of a preferred polycarbosiloxane.

An example of a particularly suitable component (B') is a silicone-based surface treating agent having at least one polysiloxane structure and a hydrolyzable silyl group in a molecule. Most suitably, it is preferable to use a silicone-based surface treatment agent having at least one polysiloxane structure and a hydrolyzable silyl group per molecule, with examples thereof including organopolysiloxanes having a straight-chain alkoxysilyl terminal expressed by

Structural formula (1): R'ₙ(RO)₃₋ₙSiO-(R'₂SiO)ₘ-SiR'ₙ(RO)₃₋ₙ

or

Structural formula (2): R'₃SiO-(R'₂SiO)ₘ-SiR'ₙ(RO)₃₋ₙ

In the formulas, R represents a hydrogen atom or an alkyl group having 1 to 3 carbon atoms (= methyl group, ethyl group, or propyl group), while each R' independently represents an alkyl group having 1 to 20 carbon atoms, a halogen-substituted alkyl group having 1 to 20 carbon atoms, an alkenyl group having 2 to 20 carbon atoms, an aryl group having 6 to 20 carbon atoms, a halogen-substituted aryl group having 6 to 20 carbon atoms, or an aralkyl group having 7 to 20 carbon atoms, with the same groups as those described above being exemplified. "n" is a number in the range of 0 to 2, while "m" is a number in the range of 2 to 200 and may be a number in the range of 2 to 150.

Such component (B) is preferably at least one filler which does not have a softening point or does not soften at or below the softening point of component (A1) and may be a component which improves the handling workability of the present composition, in addition to imparting mechanical properties and other properties to the cured product of the present composition. Examples of component (B) include reinforcing fillers, pigments (particularly black pigments or white pigments), thermally conductive fillers, electrically conductive fillers, phosphors, and mixtures of at least two thereof, and in particular, 40% or more of the total component (B) preferably contains a reinforcing filler with an average particle size of 10.0 µm or more in order to achieve a high vol.% filling amount. Examples of the organic filler include silicone resin fillers, fluorine resin fillers, and polybutadiene resin fillers. Note that the shape of these fillers is not particularly limited and may be spherical, spindle-shaped, flat, needle-shaped, plate-shaped, amorphous, or the like.

The present composition imparts mechanical strength and improves protective and adhesive properties in the cured product when used in a sealing agent, protective agent, adhesive, and light reflective material and the like. Therefore, a reinforcing filler is preferably added as component (B). Examples of the reinforcing filler include fumed silica, precipitable silica, fused silica, calcined silica, fumed titanium dioxide, quartz, calcium carbonate, silica earth, aluminum oxide, aluminum hydroxide, zinc oxide, zinc carbonate, glass beads, glass powder, talc, clay and mica, kaolin, silicon carbide, silicon nitride, aluminum nitride, carbon black, graphite, titanium dioxide, calcium sulfate, barium carbonate, magnesium carbonate, magnesium sulfate, barium sulfate, cellulose, aramid, and the like. Furthermore, these reinforcing fillers may also be surface treated with: methyltrimethoxysilane or other organoalkoxysilane; trimethylchlorosilane or other organohalosilane; hexamethyldisilazane or other organosilazane; dimethylsiloxane oligomers blocked with an α,ω-silanol group, methylphenylsiloxane oligomers blocked with an α,ω-silanol group, methylvinylsiloxane oligomers blocked with an α,ω-silanol group, or other siloxane oligomers; or the like. Furthermore, examples of the reinforcing filler that may be used include: calcium metasilicate, potassium titanate, magnesium sulfate, sepiolite, zonolite, aluminum borate, rock wool, glass fiber, carbon fiber, asbestos fiber, metal fiber, wollastonite, attapulgite, sepiolite, aluminum borate whisker, potassium titanate fiber, calcium carbonate whisker, titanium oxide whisker, ceramic fiber, and other fibrous inorganic fillers; and aramid fiber, polyimide fiber, polyparaphenylene benzobisoxazole fiber, and other fibrous fillers. Furthermore, the following may also be used: talc, kaolin clay, calcium carbonate, zinc oxide, calcium silicate hydrate, mica, glass flakes, glass powder, magnesium carbonate, silica, titanium oxide, alumina, aluminum hydroxide, magnesium hydroxide, barium sulfate, calcium sulfate, calcium sulfite, zinc borate, barium metaborate, aluminum borate, calcium borate, sodium borate, aluminum nitride, boron nitride, silicon nitride, pulverized products of the fibrous fillers above, and other plate-shaped fillers or granular fillers.

In particular, from the viewpoint of imparting the hardness of the cured product at room temperature to high temperature, component (B) in the present composition is preferably spherical silica or aluminum oxide (alumina) having an average particle diameter of 10.0 µm or more.

Component (B) may contain silicone microparticles that do not have hot-melt properties such that stress relaxation properties and the like can be improved or adjusted as desired. While silicone microparticles include non-reactive silicone resin microparticles and silicone elastomer microparticles, silicone elastomer microparticles are suitably exemplified from the perspective of improving flexibility or stress relaxation properties.

The silicone elastomer microparticles are a cross-linked product of linear diorganopolysiloxane primarily including a diorganosiloxy unit (D units). The silicone elastomer microparticles can be prepared by a cross-linking reaction of diorganopolysiloxane by a hydrosilylation reaction, a condensation reaction of a silanol group, or the like. In particular, the silicone elastomer microparticles can be suitably obtained by a cross-linking reaction of an organohydrogenpolysiloxane having a silicon-bonded hydrogen atom at a side chain or an end with a diorganopolysiloxane having an unsaturated hydrocarbon group, such as an alkenyl group or the like, at a side chain or an end under a hydrosilylation reaction catalyst. The silicone elastomer microparticles may have various shapes such as spherical, flat, and irregular shapes, but are preferably spherical from the perspective of dispersibility, with true spherical being particularly preferable. Commercially available products of such silicone elastomer fine particles (B) include, for example, "Torefil-E series" and "EP Powder series" manufactured by Dow Corning Toray Company, Ltd., and "KMP series" manufactured by Shin-Etsu Chemical Co., Ltd. Note that the silicone elastomer microparticles may be subjected to surface treatment.
Furthermore, the elastomer microparticles may be acrylnitrile butadiene rubber, isoprene, styrene butadiene rubber, ethylene propylene rubber, or the like.

When the present composition is used as a wavelength conversion material for an LED, a phosphor may be blended as component (B) to convert the emission wavelength from the optical semiconductor element. The phosphor is not particularly limited, and examples thereof include yellow, red, green, and blue light phosphors and the like, which include oxide phosphors, oxynitride phosphors, nitride phosphors, sulfide phosphors, oxysulfide phosphors, and the like and are widely used in light-emitting diodes (LED). Examples of the oxide phosphors include: yttrium, aluminum, and garnet-type YAG green to yellow light phosphors containing cerium ions; terbium, aluminum, and garnet-type TAG yellow light phosphors containing cerium ions; and silicate green to yellow light phosphors containing cerium or europium ions. Furthermore, examples of oxynitride phosphors include silicon, aluminum, oxygen, and nitrogen type SiAlON red to green light phosphors containing europium ions. Examples of nitride phosphors include calcium, strontium, aluminum, silicon, and nitrogen type CASN red light phosphors containing europium ions. Examples of sulfide phosphors include ZnS green light phosphors containing copper ions or aluminum ions. Examples of oxysulfide phosphors include Y₂O₂S red light phosphors containing europium ions. In the present composition, two or more of these phosphors may be used in combination.

Furthermore, the present composition may contain a thermally conductive filler or an electrically conductive filler to impart thermal or electrical conductivity to the cured product. Examples of the thermally conductive filler or the electrically conductive filler include: metal fine powders such as gold, silver, nickel, copper, aluminum, tin, lead, zinc, bismuth, antimony, and the like; fine powders obtained by depositing or plating a metal such as gold, silver, nickel, copper or the like on the surface of a fine powder of ceramic, glass, quartz, organic resin or the like; metal compounds such as aluminum oxide, magnesium oxide, aluminum nitride, boron nitride, zinc oxide, or the like; graphite; and mixtures of two or more thereof. When electrical insulation is required for the present composition, a metal oxide-based powder or a metal nitride-based powder is preferable, and an aluminum oxide powder, a zinc oxide powder, or an aluminum nitride powder is particularly preferable.

Furthermore, the present composition may contain a pigment to provide the cured product with color. Examples of such pigments include white pigments, black pigments, and other colorants.

The white pigment is a component that imparts whiteness to the cured product and improves light reflectivity, and the cured product resulting from curing the composition by blending the component can be used as a light reflective material for light emitting/optical devices. Examples of the white pigment include metal oxides such as titanium oxide, aluminum oxide, zinc oxide, zirconium oxide, magnesium oxide, and the like; hollow fillers such as glass balloons, glass beads, and the like; and additionally, barium sulfate, zinc sulfate, barium titanate, aluminum nitride, boron nitride, and antimony oxide. Titanium oxide has high optical reflectivity and concealing properties, and is therefore preferable. Furthermore, aluminum oxide, zinc oxide, and barium titanate have high optical reflectivity of a UV region, and are therefore preferable. The average particle size or shape of the white pigment is not restricted, but the average particle diameter is within a range of 0.05 to 10.0 µm and preferably within a range of 0.1 to 5.0 µm. Furthermore, surface treatment of the white pigment can be performed using a silane coupling agent, silica, aluminum oxide, and the like.

Examples of black pigments and other colorants include black titanium oxide, pitch (residue from distillation of tar obtained by dry distillation of organic substances such as oil, coal, wood, and the like), carbon black, acetylene black, red iron oxide, and the like. Acetylene black can be suitably used when reducing the amount of metal impurities. Furthermore, black dyes may be included, such as anthraquinone dyes (sometimes referred to as "anthraquinone"), azine dyes, azo dyes, disazo dyes, chromium complex dyes, and the like, and when used in combination with a yellow dye, such as methine dyes, disazo dyes, azocobalt complex dyes, azochrome complex dyes, and the like, the color can approach that of a black pigment.

Furthermore, black titanium oxide and pitch can be suitably used to improve the laser marking property of the resulting cured product. Thereby, absorption of laser energy by the pigment can be prevented from becoming excessively large during laser marking. Therefore, excessively deep portions can be prevented from appearing in the print due to the pigment being lost by the laser. In addition, carbonization can be easily suppressed. In other words, variation in the maximum depth relative to the average depth can be suppressed, and variation in the printing depth profile can be reduced.

Black titanium oxide exists as TiₙO₍₂ₙ₋₁₎ (where n is a positive integer). The black titanium oxide TiₙO₍₂ₙ₋₁₎ used in the present embodiment is preferably one in which n is 4 or more and 6 or lower. By making n equal to or greater than 4, the dispersibility of the pigment in the resin composition can be improved. On the other hand, by setting n to 6 or lower, the laser marking properties can be improved. Here, the pigment preferably contains at least one of Ti ₄O₇, Ti₅O₉, and Ti₆O₁₁ as black titanium oxide.
Pitch is the residue obtained by distilling tar, which is obtained by dry distillation of organic substances such as petroleum, coal, wood, and the like. The pitch used as a pigment is not particularly limited, but may be, for example, petroleum pitch or coal pitch. The pitch may be isotropic pitch, mesophase pitch, or mesophase spheres produced by cooling mesophase pitch and separated as an insoluble component in quinoline. Among these, the use of mesophase microspheres is preferable from the viewpoint of improving laser marking properties and dispersibility in the encapsulating resin composition.

Furthermore, the present composition may optionally contain a thermal expansive filler. The inclusion of the thermal expansive filler may improve the volume expansion rate of the composition according to the present invention and reduce uneven distribution of the composition. The thermal expansive filler above is preferably a core-shell structure and contains a volatile expansion agent inside the shell of the core-shell structure. Herein, volatile expansion agent refers to a substance that generates gas at a temperature at or below the softening point of the shell, and the thermal expansive filler has a structure in which the volatile expansion agent is encapsulated as a core agent inside a gas barrier shell. Therefore, heat can cause the volatile expansion agent to be gaseous and the shell to soften and expand. Such components are exemplified in, for example, Japanese Unexamined Patent Application 2020-084094 and the like, and are available as FN-100SSD and FN-80GSD manufactured by Matsumoto Yushi-Seiyaku Co., Ltd., and the like.

When the cured product obtained by curing the present composition is used for powder magnetic needles, coils, electromagnetic shielding materials, and other magnetic members, the cured product may contain magnetic particles as component (B). Such magnetic particles contain one or more elements selected from the group consisting of Fe, Cr, Co, Ni, Ag, and Mn. In particular, soft magnetic particles may include magnetic particles made of iron (Fe), Fe-Si alloy, Fe-Al alloy, Fe-Ni alloy, Fe-Co alloy, Fe-Si-Al alloy, Fe-Si-Cr alloy, Fe-Cr alloy, carbonyl iron, stainless steel, and the like. From the perspective of availability, magnetic particles may be made of carbonyl iron. Similar to the inorganic fillers mentioned earlier, these magnetic particles may be surface treated with a silane compound, titanate compound, aluminate compound, or partial hydrolyzate thereof, which may prevent deactivation of the curing catalyst or cross-linking agent and improve storage stability. In addition, these magnetic particles may have a surface coating layer containing a siloxane polymer, for example, by a method described in Japanese Unexamined Patent Application 2021-036013, and the like.

### [Component (C)]

Component (C) is one of the characteristic components of the curable silicone composition of the present invention. When the amount of component (B) in the composition is 40 parts by mass or more per 100 parts by mass of component (A), this component improves mold removability during molding of the cured product obtained by curing the composition while achieving a high content of functional inorganic filler.

Specifically, component (C) is a polyolefin wax having a melting point of 130°C or lower and a melt viscosity at 140°C of 100 mPas or higher. Specific examples include polyethylene wax, oxidized polyethylene wax, polypropylene wax, oxidized polypropylene wax, and mixtures thereof, but any polyolefin wax may be used as long as the wax satisfies the above melting point and melt viscosity characteristics. Note that polyolefin waxes satisfying the aforementioned properties are widely commercially available from Sanyo Chemical Industries, Ltd., Clariant Chemicals K.K., and the like.

The preferred amount of component (C) to be added will be described below. In order for this component to exhibit sufficient mold removability, component (C) is preferably kneaded together with the composition at a temperature equal to or higher than the melting point or at a temperature close to this temperature, and dispersed uniformly. From the viewpoint of the melt-kneading conditions for the present composition described below, the melting point of component (C) must be 130°C or lower, or 120°C or lower, and the melting point may be in a range of 60 to 130°C, 60 to 125°C, 60 to 120°C, or 60 to 120°C. On the other hand, if the melting point of component (C) exceeds the upper limit, improving the mold removability of the cured product during molding might not be possible. Similarly, from the standpoint of ensuring the adhesive strength to a substrate by a cured product formed from the curable silicone composition of the present invention, the melt viscosity of component (C) at 140°C must be 100 mPas or greater, and may be in a range of 100 to 10000 mPas, 100 to 7500 mPas, or 500 to 5500 mPas. On the other hand, if the melt viscosity of component (C) at 140°C is less than the lower limit, the mold removability of the cured product may be excessive, preventing adhesion to the base material or substrate. Note that, when component (A) is a thermosetting silicone that undergoes an addition curing reaction, particularly a hydrosilylation reaction, component (C) preferably has an acid value of 50 mg KOH/g or less, from the perspective of preventing curing inhibition.

### [Component (D)]

Component (D) is an optional component of the curable silicone composition of the present invention that presupposes use of component (C). Specifically, component (D) is a wax having a melting point of 130°C or lower and a viscosity at 140°C of less than 100 mPas, and is characterized by having a low melting point and a lower melt viscosity at 140°C than component (C). Note that, waxes satisfying the aforementioned properties are widely commercially available from Sasol Ltd., Riken Vitamin Co., Ltd., Toa Kasei Co., Ltd., and the like.

By using component (D) in combination with component (C), a balance can be achieved between the flowability and mold removability when the composition is molded, and the adhesive strength to the substrate by the resulting cured product. Specifically, component (C) has too high of a high melt viscosity, so low melt viscosity and excellent flowability cannot be imparted to the composition during melting when using only this component. However, by adding a second wax component having a melting point of 130°C or lower and a melt viscosity of less than 100 mPas at 140°C, the above three properties can be simultaneously achieved. On the other hand, if the present composition lacks component (C) and only contains component (D), the adhesive strength and mold removability may be insufficient. In other words, in the present invention, the use of component (D) is premised on the use of component (C).

Component (D) may be any wax that satisfies the melting point and melt viscosity requirements, and examples thereof include petroleum waxes such as paraffin and the like, natural waxes such as carnauba wax and the like, Montan acid ester wax, fatty acid esters of erythritol derivatives, and synthetic waxes such as Fischer-Tropsch wax and the like. The addition of component (D) in a small amount reduces the melt viscosity and improves flowability of the composition, and the preferred amount thereof will be described later. The melting point of component (D) must be 130°C or lower, or 100°C or lower, and may be in the range of 60 to 120°C, 60 to 100°C, 60 to 100°C, or 60 to 90°C. Furthermore, the melt viscosity of component (D) at 140°C must be less than 100 mPas, and may be in the range of 1 to 99 mPas, 5 to 95 mPas, or 5 to 50 mPas. Note that when component (A) is an addition-cure thermosetting silicone, the acid value of component (D) is preferably 50 mg KOH/g or less, from the standpoint of being less likely to cause curing inhibition.

### [Amounts of components (C) and (D)]

The composition of the present invention is primarily used as a sealant for sealing a substrate, and for this application, the sealant preferably adheres firmly to the substrate. Therefore, if the added amount of component (C) or component (D) is too large, the adhesive properties of the resulting cured product may be impeded. In particular, from the viewpoint of achieving good adhesive properties and mold removability of the cured product, as well as flowability of the composition when heated and melted, the amount of component (C) added may be in a range of 0.01 to 0.50 parts by mass, 0.01 to 0.40 parts by mass, or 0.02 to 0.30 parts by mass, where the total amount of the composition is 100 parts by mass. Similarly, the added amount of component (D) may be in a range of 0.01 to 0.50 parts by mass, 0.01 to 0.40 parts by mass, or 0.02 to 0.30 parts by mass. Note that if the amount of component (D) used is excessive relative to the amount of component (C), the technical effects of the present invention may not be sufficiently achieved. Therefore, in practice, the mass ratio of component (C) to component (D) is preferably within a range of 1:4 to 4:1, 1:3 to 3:1, or 1:2 to 2:1. Furthermore, the adhesive strength may be impaired if the total amount of component (C) and component (D) is too large, so the total amount is preferably 0.50 parts by mass or less, 0.40 parts by mass or less, or 0.30 parts by mass or less, based on the total amount of the composition being 100 parts by mass.

### [Use as a release coating agent on mold surfaces]

On the other hand, the composition of the present invention can also be used as a composition for treating the surface of a mold that applies a release coating to the surface of the mold of a molding machine before molding the aforementioned sealant composition. For this application, the composition is not required to exhibit adhesion to the substrate, but must form a sufficient release coating on the mold surface during the molding process. In this case, the amount of component (C) added is preferably 0.1 to 5.0 parts by mass, 0.3 to 4.0 parts by mass, or 0.5 to 3.5 parts by mass, based on 100 parts by mass of the entire composition. Depending on the shape of the mold, component (D) may be used in combination, and a suitable amount thereof is 0.1 to 5.0 parts by mass, 0.3 to 4.0 parts by mass, or 0.5 to 3.5 parts by mass, relative to 100 parts by mass of the entire composition. If the added amount of component (C) and component (D) is within the above ranges, a release coating can be effectively applied to the surface of the mold of the molding machine. Wax components other than component (C) and component (D) may be used, depending on the composition of the sealant composition to be actually molded and the shape of the mold. Furthermore, the moldability and releasability may be further improved by first using a composition containing a high amount of component (C) or component (D) to effectively apply a release coating to the surface of a mold, and then molding a composition containing a low total amount of component (C) and component (D) as a sealant composition for sealing a substrate or the like.

The composition of the present invention may contain (E) a cure retarder and (F) an adhesion promoter, provided that the object of the present invention is not impaired.

Component (E) is a curing retarder, which may effectively suppress side reactions, particularly when the present composition is thermally cured by a hydrosilylation reaction, and may further improve the storage stability of the composition according to the present invention, the usable time when heated and melted, and the like.

The available curing retarders are not particularly limited in structure and type and can be selected from known hydrosilylation reaction inhibitors. Examples thereof include: 2-methyl-3-butyn-2-ol, 3,5-dimethyl-1-hexyn-3-ol, 2-phenyl-3-butyn-2-ol, 1-ethynyl-1-cyclohexanol, and other alkyne alcohols; 3-methyl-3-penten-1-yne, 3,5-dimethyl-3-hexen-1-yne, and other enyne compounds; tetramethyltetravinylcyclotetrasiloxane, tetramethyltetrahexenylcyclotetrasiloxane, and other alkenyl group-containing low molecular weight siloxanes; methyl-tris(1,1-dimethyl-2-propynyloxy)silane, vinyl-tris(1,1-dimethylpropynyloxy)silane, and other alkynyloxysilanes; and bis(alkynyloxysilyl)alkanes expressed by the following formula. 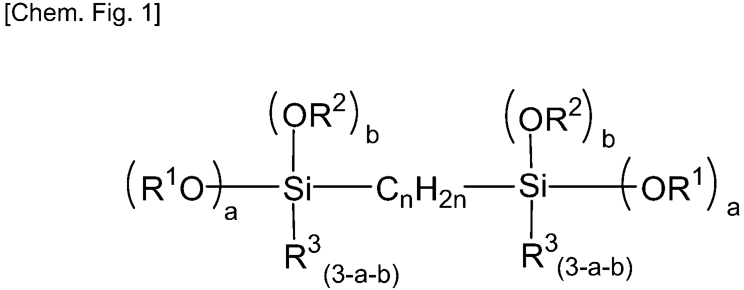 (where R¹ independently represents an alkynyl group having 5 to 12 carbon atoms, R² independently represents an alkyl group having 1 to 3 carbon atoms or a hydrogen atom, R³ independently represents an alkyl group having 1 to 3 carbon atoms, "a" independently represents 1, 2, or 3, "b" independently represents 0, 1, or 2, and "a + b" is 2 or 3, where at least one of "b" is 1 or 2, and "n" represents an integer from 2 to 20).

In the formula, R¹ preferably represents an alkynyl group expressed by the formula: 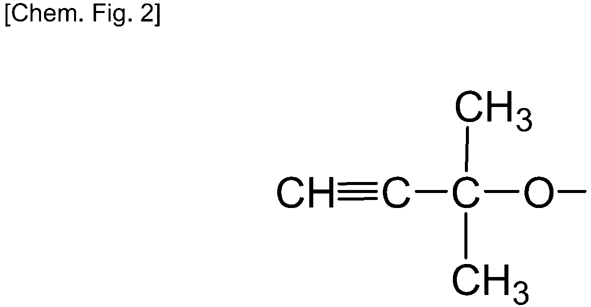
an alkynyl group expressed by the formula: 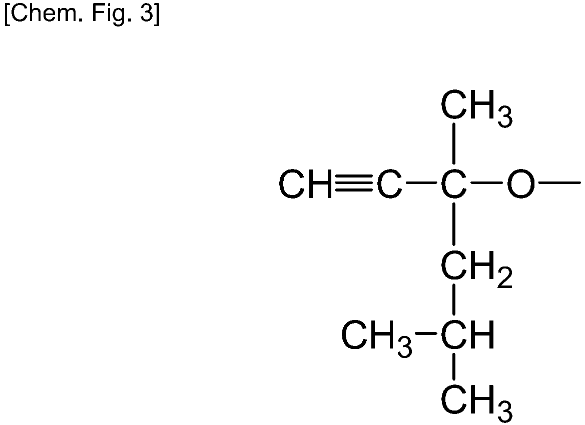
or an alkynyl group expressed by the formula:

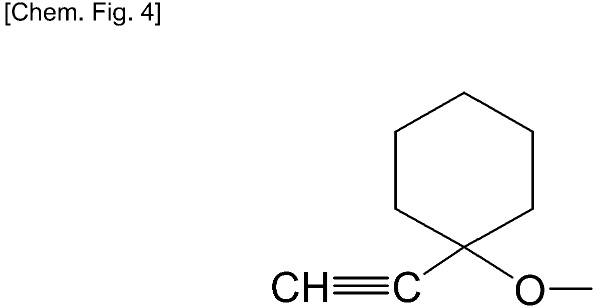

A compound with a boiling point of 200°C or higher under atmospheric pressure is particularly preferably used as component (E). This is because the granular composition according to the present invention can be granulated through a process involving heating, such as melt kneading and the like of the composition, from the perspective of compositional homogeneity, but if a compound with a low boiling point is used as a curing retarder, some or all of the curing retarder may volatilize during the melt kneading process required for granulation. Moreover, the curing retardant effect on the final granular curable silicone composition may not be achieved. Note that methyl-tris(1,1-dimethyl-2-propynyloxy)silane and bis(alkynyloxysilyl)alkanes have boiling points under atmospheric pressure of 245°C and 300°C or higher, respectively, and thus are preferred examples of component (E).

The amount of component (E) used is arbitrary, but is preferably in the range of 1 to 10,000 ppm in mass units with respect to the entire composition.

Component (F) is an adhesion imparting agent, and examples include organic silicon compounds having at least one alkoxy group bonded to a silicon atom in one molecule. Examples of the alkoxy group include methoxy groups, ethoxy groups, propoxy groups, butoxy groups, and methoxyethoxy groups, with methoxy groups being particularly preferable. Furthermore, examples of groups bonded to a silicon atom other than the alkoxy groups in the organic silicon compound include: halogen-substituted or unsubstituted monovalent hydrocarbon groups such as alkyl groups, alkenyl groups, aryl groups, aralkyl groups, halogenated alkyl groups, and the like; glycidoxyalkyl groups such as 3-glycidoxypropyl groups, 4-glycidoxybutyl groups, and the like; epoxycyclohexylalkyl groups such as 2-(3,4-epoxycyclohexyl)ethyl groups, 3-(3,4-epoxycyclohexyl)propyl groups, and the like; epoxyalkyl groups such as 3,4-epoxybutyl groups, 7,8-epoxyoctyl groups, and the like; acrylic group-containing monovalent organic groups such as 3-methacryloxypropyl groups and the like; and hydrogen atoms. This organic silicon compound preferably has a group that may react with an alkenyl group or a silicon atom-bonded hydrogen atom in the present composition, and specifically, preferably has a silicon atom-bonded hydrogen atom or an alkenyl group. Furthermore, favorable adhesion can be imparted to various base materials, and thus this organic silicon compound preferably has at least one epoxy group-containing monovalent organic group in one molecule. Examples of such organic silicon compounds include organosilane compounds, organosiloxane oligomers, and alkyl silicates. Examples of molecular structures of this organosiloxane oligomer or alkyl silicate include linear structures, partially branched linear structures, branched structures, cyclic structures, and network structures, of which linear structures, branched structures, and network structures are particularly preferable. Examples of the organic silicon compound include: silane compounds such as 3-glycidoxypropyltrimethoxysilane, 2-(3,4-epoxycyclohexyl) ethyltrimethoxysilane, 3-methacryloxypropyltrimethoxysilane, and the like; siloxane compounds having at least one silicon atom-bonded alkenyl group or silicon atom-bonded hydrogen atom and one silicon atom-bonded alkoxy group in one molecule; mixtures of a silane compound or siloxane compound having at least one silicon atom-bonded alkoxy group and a siloxane compound having at least one silicon atom-bonded hydroxy group and one silicon atom-bonded alkenyl group in one molecule; reaction mixtures of amino group-containing organoalkoxysilane and epoxy group-containing organoalkoxysilane; organic compounds having at least two alkoxysilyl groups in one molecule and containing bonds other than a silicon-oxygen bond between these silyl groups; epoxy group-containing silanes expressed by the general formula:

R^{a}ₙSi(OR^{b})₄₋ₙ

(wherein, R^{a} represents an organic group containing a monovalent epoxy group, while R^{b} represents an alkyl group having from 1 to 6 carbon atoms, or a hydrogen atom. n represents a number within a range of 1 to 3),
or a partially hydrolyzed condensate thereof; reaction mixtures of a vinyl group-containing siloxane oligomer (including those with chain or cyclic structures) and an epoxy group-containing trialkoxysilane; methyl polysilicates; ethyl polysilicates; and epoxy group-containing ethyl polysilicates. The adhesion imparting agent is preferably in the form of a low viscosity liquid, and the viscosity thereof is not limited, but is preferably within the range of 1 to 500 mPa·s at 25°C. Furthermore, while not limited thereto, the amount of the adhesion imparting agent is preferably within the range of 0.01 to 10 parts by mass with respect to a total of 100 parts by mass of the present composition.

In the present invention, a reaction mixture of an organoalkoxysilane containing an amino group and an organoalkoxysilane containing an epoxy group is an example of a particularly preferable adhesion imparting agent. Such a component improves the initial adhesion of the curable silicone composition to various substrates with which the composition is in contact during a curing process, particularly low-temperature adhesion even to an unwashed adherend. Such a reaction mixture is disclosed in Japanese Examined Patent Publication S52-8854 and Japanese Unexamined Patent Application H10-195085.

Examples of alkoxysilanes having an amino group-containing organic group forming such component include an aminomethyltriethoxysilane, 3-aminopropyltrimethoxysilane, 3-aminopropyltriethoxysilane, 3-aminopropylmethyldimethoxysilane, N-(2-aminoethyl)aminomethyltributoxysilane, N-(2-aminoethyl)-3-aminopropyltrimethoxysilane, N-(2-aminoethyl)-3-aminopropylmethyldimethoxysilane, and 3-anilinopropyltriethoxysilane.

Furthermore, examples of epoxy group-containing organoalkoxysilanes include 3-glycidoxyprolyltrimethoxysilanes, 3-glycidoxypropylmethyldimethoxysilanes, 2-(3,4-epoxy cyclohexyl)ethyltrimethoxysilanes, and 2-(3,4-epoxy cyclohexyl)ethylmethyldimethoxysilanes.

The ratio of the alkoxysilane having an amino group-containing organic group to the alkoxysilane having an epoxy group-containing organic group is, in terms of molar ratio, preferably within the range of (1:1.5) to (1:5), and particularly preferably within the range of (1:2) to (1:4). This component can be easily synthesized by mixing an alkoxysilane having an amino group-containing organic group and alkoxysilane having an epoxy group-containing organic group as described above to cause a reaction at room temperature or by heating.

The curable hot-melt silicone composition of the present invention particularly preferably contains a carbasilatrane derivative expressed by the general formula: 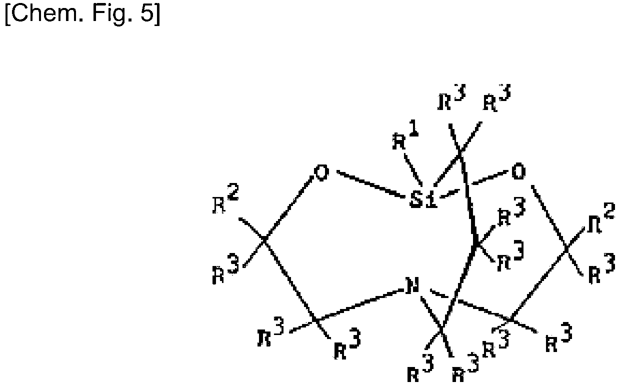
{where R¹ represents an alkyl group, an alkenyl group, or an alkoxy group, and R² represents the same or different group selected from the group consisting of groups expressed by the general formula: 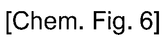 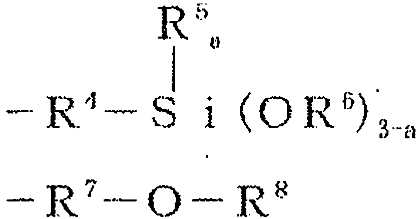
(where R⁴ represents an alkylene group or alkyleneoxyalkylene group, R⁵ represents a monovalent hydrocarbon group, R⁶ represents an alkyl group, R⁷ represents an alkylene group, R⁸ represents an alkyl group, alkenyl group, or acyl group, and "a" represents 0, 1, or 2.), and
R³ represents the same or different hydrogen atom or alkyl group.},
the carbasilatrane derivative being obtained by reacting an alkoxysilane having an amino group-containing organic group with an epoxy group-containing organic group and then cyclizing by an alcohol exchange reaction, by a method described in Japanese Unexamined Patent Application H10-195085. Examples of such carbasilatrane derivatives include carbasilatrane derivatives having a silicon atom-bonded alkoxy group or a silicon atom-bonded alkenyl group in one molecule expressed by the following structure: 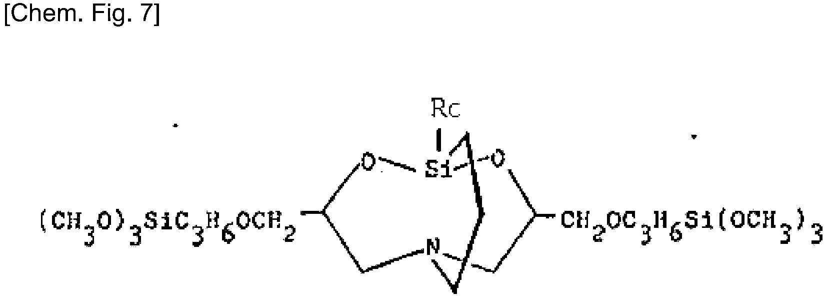
(where Rc represents a group selected from methoxy groups, ethoxy groups, vinyl groups, allyl groups, and hexenyl groups.)

Furthermore, in the present invention, a silatrane derivative expressed by the following structural formula may be used as the adhesion imparting agent. 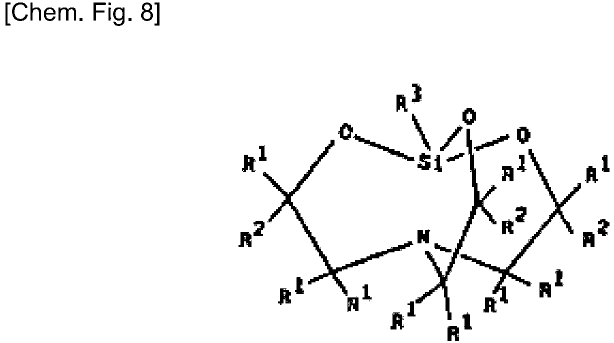 In the formula, R¹ represents the same or different hydrogen atom or alkyl group, with R¹ particularly preferably being a hydrogen atom or a methyl group. Furthermore, in the formula above, R² represents the same or different group selected from the group consisting of a hydrogen atom, an alkyl group, and an alkoxysilyl group-containing organic group expressed by general formula: -R⁴-Si(OR⁵)ₓR⁶₍₃₋ₓ₎, provided that at least one R² represents an alkoxysilyl group-containing organic group. Examples of alkyl groups R² include methyl groups and the like. Furthermore, in the alkoxysilyl group-containing organic group of R², R⁴ in the formula represents a divalent organic group. Examples thereof include alkylene groups and alkyleneoxyalkylene groups, with ethylene groups, propylene groups, butylene groups, methylene oxypropylene groups, and methylene oxypentylene groups being preferable. Furthermore, R⁵ in the formula represents an alkyl group having 1 to 10 carbon atoms, and preferably a methyl group or an ethyl group. Furthermore, R⁶ in the formula represents a substituted or unsubstituted monovalent hydrocarbon group, and preferably a methyl group. Furthermore, in the formula, x represents 1, 2, or 3, and preferably 3.

Examples of such alkoxysilyl group-containing organic groups of R² include the following groups:

-(CH₂)₂Si(OCH₃)₂(CH₂)₂Si(OCH₃)₂CH₃

-(CH₂)₃Si(OC₂H₅)₂(CH₂)₃Si(OC₂H₅)(CH₃)₂

-CH₂O(CH₂)₃Si(OCH₃)₃

-CH₂O(CH₂)₃Si(OC₂H₅)₃

-CH₂O(CH₂)₃Si(OCH₃)₂CH₃

-CH₂O(CH₂)₃Si(OC₂H₅)₂CH₃

-CH₂OCH₂Si(OCH₃)₂CH₂OCH₂Si(OCH₃)(CH₃)₂

R³ in the formula above represents at least one group selected from the group consisting of substituted or unsubstituted monovalent hydrocarbon groups, alkoxy groups having 1 to 10 carbon atoms, glycidoxyalkyl groups, oxiranylalkyl groups, and acyloxyalkyl groups. Examples of monovalent hydrocarbon groups of R³ include alkyl groups such as methyl groups and the like. Examples of alkoxy groups of R³ include methoxy groups, ethoxy groups, propoxy group, and the like. Examples of glycidoxypropyl groups of R³ include 3-glycidoxypropyl groups and the like. Examples of oxiranylalkyl groups of R³ include 4-oxiranylbutyl groups, 8-oxiraniloctyl groups, and the like. Examples of acyloxyalkyl groups of R³ include acetoxypropyl groups, 3-methacryloxypropyl groups, and the like. In particular, R³ preferably represents an alkyl group, an alkenyl group, or an alkoxy group, and more preferably an alkyl group or an alkenyl group, and particularly preferred examples thereof include groups selected from methyl groups, vinyl groups, allyl groups, and hexenyl groups.

The amount of component (F) used is not particularly limited, but from the perspective of improving adhesion to difficult-to-adhere substrates, the amount is preferably in the range of 0.1 to 1.0 mass% of the total composition, with 0.2 to 1.0 mass% being more preferred. Furthermore, the amount of component (F) added may be in a range of 5 to 50 parts by weight, or may be in the range of 5 to 40 parts by weight, based on 100 parts by weight of component (A).

Furthermore, the present composition may contain, as other optional components: iron oxide (red iron oxide), cerium oxide, cerium dimethylsilanolate, fatty acid cerium salts, cerium hydroxide, zirconium compounds, and other heat-resistant agents, dyes, non-white pigments, flame retardancy-imparting agents, aluminum hydroxide, magnesium hydroxide, zinc borate, zinc molybdate, phosphazene, and other heat reducers, hydrotalcite, bismuth oxides, yttrium oxides, and other ion scavengers and pH adjusters, aluminum hydroxide, magnesium hydroxide, zinc borate, zinc molybdate, phosphazene, and other flame retardants, hindered phenol compounds, hindered amine compounds, thioether compounds, and other antioxidants, pure iron, silicon steel, iron-cobalt alloy, iron-nickel alloy, iron-chromium alloy, iron-aluminum alloy, carbonyl iron, stainless steel, composite materials containing one or more thereof, and other soft magnetic particles, inorganic flame retardants (such as aluminum hydroxide and other hydrated metal compounds), halogenated flame retardants, phosphorus-based flame retardants, organometallic salt-based flame retardants, silicone oil, silicone rubber, polyisoprene, 1,2-polybutadiene, 1,4-polybutadiene, and other polybutadienes, styrene-butadiene rubber, acrylonitrile-butadiene rubber, butadiene acrylonitrile rubber blocked with a carboxyl group at an end, polychloroprene, poly(oxypropylene), poly(oxytetramethylene) glycol, polyolefin glycol, poly-ε-caprolactone, and other thermoplastic elastomers, polysulfide rubber, fluoroelastomer, and other stress reducing agents, barium titanate (BaTiO₃), strontium titanate (SrTiO₃), lead zirconate titanate (Pb(Zr, Ti)O₃, PZT), alumina (Al₂O₃, aluminum oxide), zirconia (ZrO₂, zirconium dioxide), magnesia (MgO, magnesium oxide), silica (SiO₂, silicon dioxide), titania (TiO₂, titanium dioxide), aluminum nitride (AIN), silicon nitride (Si₃N₄), silicon carbide (SiC), barium calcium titanate zirconate (BCTZ), polyvinylidene fluoride, and other dielectric ceramics, copper chloride, cuprous iodide, copper acetate, cerium stearate, and other metal salt stabilizers, hindered amine-based organic compounds, hindered phenol-based organic compounds, sulfur-containing compound-based organic compounds, acrylate-based organic compounds, and phosphorus-based organic compounds, and other antioxidants and heat stabilizers; benzophenones, salicylates, benzotriazoles, and other UV absorbers, weathering agents, light stabilizers, and the like, so long as the object of the present invention is not impaired.

### [Granular curable silicone composition]

The curable silicone composition of the present invention is not particularly limited in terms of form, so long as having the aforementioned composition, and as described below, the composition may be molded into pellet-shaped molded products or tablet-shaped molded products. However, the composition has excellent melting and curing properties, characterized by high fluidity at high temperatures, and is less likely to generate dust, even though containing a large amount of functional inorganic filler, so the various components of the composition are preferably melt-kneaded at a temperature in a range of 50 to 150°C in order to homogenize the composition, and then molded into granules. In other words, the curable silicone composition according to the present invention is preferably a granular curable silicone composition. Note that the granular curable silicone composition (granular molded product) may be further molded into pellet-shaped molded product or tablet-shaped molded product.

The granular composition generates little dust, is easy to handle, and has excellent uniformity of each component. Therefore, the cured product has high hardness, a low coefficient of linear expansion, and excellent adhesion to substrates, making the cured product particularly suitable for use as sealing, molding, and protective members for semiconductor devices. Furthermore, the granular composition (granular molded product) according to the present invention has the advantage of being efficiently produced by a simple mixing process.

### [Composition of the present invention and tablet-molded product]

As noted above, the curable silicone composition of the present invention is a solid at room temperature, but in order for component (C) and the optional component (D) to sufficiently exert effects in small amounts, the composition is preferably homogenized, and as noted above, the curable silicone composition is preferably molded into granules. Furthermore, the granular composition can be tableted by a known method and used in the form of a pellet-shaped molded product or a tablet-shaped molded product by forming the granular composition into granules having a certain average particle size. Unlike the tablet molding of granular compositions (powder mixture) that have not been melt-kneaded as in Patent Document 1 and the like, the granular curable silicone composition according to the present invention is compositionally homogeneous. Therefore, the use of the same granular composition has the advantage of not only superior production efficiency of the tableted molded product, but also superior hot-melt properties, melt viscosity, and physical properties of the cured product of the resulting tableted molded body. Furthermore, granular compositions have the advantage creating less dust.

Herein, "pellet" and "tablet" are common names for granular tableted molded products containing a resin composition. The shape of the pellet/tablet is not limited, but is usually spherical, oval or cylindrical. Furthermore, the size of the pellet is not limited, but the pellet may, for example, have an average particle size or equivalent circular diameter of 500 µm or more or have an average particle size or equivalent circular diameter of 1 mm or more.

### [Method for Manufacturing Granular Curable Silicone Composition]

The present composition is in the form of compositionally homogenized granules in which the entire composition, including at least the aforementioned components (A) to (C) and the like, is compositionally homogenized beyond the degree of mere mechanical force mixing. Such granular compositions are preferably obtained by melt kneading the entire composition with heating. More specifically, component (A) to component (C) are preferably melt kneaded, as well as any other optional components, in the temperature range of 50 to 150°C in a uniaxial or biaxial continuous mixer, dual rollers, roth mixer, kneader mixer, or the like, and then molded into granule form for use. Specific production methods are exemplified below.

The method for manufacturing the granular curable silicone composition of the present invention includes a step of melt-kneading a curable silicone composition containing the above components (A) to (C) and other optional components, the amount of component (B) being 40 parts by mass or more per 100 parts by mass of component (A), at a temperature range of 50 to 150°C, and then molding the composition into granules.
Here, the average particle size of the granular composition is preferably in a range of 0.05 to 10.0 mm.

The production method is not particularly limited so long as including a step of melt-kneading the composition and then molding the composition into granules, and includes, for example, the following steps 1 to 3.
Step 1: Kneading the components of the curable silicone composition while heating and melting in the temperature range of 50 to 150°C
Step 2: Cooling the heated and melted mixture obtained in step 1 while discharging
Step 3: Cutting or pulverizing the mixture obtained in step 2 and then molding into a granular curable silicone composition

### [Step 1]

Step 1 above is a step for kneading the components of the curable silicone composition of the present invention while heating and melting in the temperature range of 50 to 150°C. Moreover, by heating and kneading the mixture having hot-melt properties at a temperature greater than or equal to the softening point thereof, and preferably in the temperature range of 50°C to 120°C, the entire composition is melted or softened and components (A) to (C) and optional components can be homogenously dispersed throughout. In particular, by melt-kneading component (C) and, optionally, component (D) at a temperature higher than or close to the melting point of these components, the components can be uniformly dispersed within the system, allowing the components to sufficiently exert the effects.

The mixing device in step 1 is not limited, and can be: a kneader, a Banbury mixer, a Henschel mixer, a planetary mixer, a two-roller mill, a three-roller mill, a Ross mixer, a Labo Plastomill, or the like, or other batch type mixer, provided with heating and cooling functions; and a single-screw extruder, a twin-screw extruder, or other continuous type heating and kneading device, provided with heating and cooling functions. The mixing device is not particularly limited, but is selected in accordance with the efficiency of the processing time and the ability to control shear heat generation. In terms of the processing time, it may be a continuous heating and kneading device such as a single-screw extruder, a twin-screw extruder, or the like, or may be a batch mixer such as a Labo Plastomill. However, from the perspective of production efficiency of the granular curable silicone composition, a continuous heating and kneading device as a single-screw extruder, twin-screw extruder, and the like are preferably used.

The mixture is made into a granular form in step 3 via step 2. However, if the temperature is less than the lower limit above, softening is insufficient, which may make it difficult to obtain a melted or softened mixture in which each component is homogeneously dispersed throughout, even by a mechanical force. Moreover, such a mixture may not have excellent homogeneity of components, and when the resulting granular curable silicone composition is used in the molding step, a homogeneous cured product may not be obtained. On the other hand, if the temperature exceeds the aforementioned upper limit, the curing agent reacts during mixing, potentially causing the entire amount thereof to undergo significant thickening or curing, thereby losing hot-melt properties and forming a cured product, which is not preferable. Therefore, when a component for a hydrosilylation reaction is used as component (A), a microparticulate hydrosilylation reaction catalyst (for example, the component (A2-2) above) dispersed or encapsulated in a thermoplastic resin with a softening point at or above the kneading temperature is preferably used as a catalyst component thereof.

As for the method for feeding the components of the present invention into the aforementioned kneading device, each component may be fed separately to the kneading device at a constant rate, or all components may be powder-mixed by a mechanical force or the like into a granular curable silicone composition before being fed into the kneading device.

### [Step 2]

Step 2 is a step for discharging the mixture melted and kneaded by step 1 from the kneading machine. The mixture can be discharged in any shape, but the mixture is cut and pulverized in step 3 into a granular form. Therefore, a shape that is easy to cut and pulverize is preferably used. Examples include rod shapes (strand shape) with a diameter of approximately 0.5 to 5.0 mm or sheet shapes with a thickness of approximately 0.5 to 5.0 mm. The mixture is preferably a non-pressure-sensitive adhesive solid for granulation in step 3, and thus the temperature of the discharged mixture must be lowered to near room temperature by natural or rapid cooling. Examples of rapid cooling methods include methods using a cooler, water cooling, and the like.

### [Step 3]

Step 3 is a step for cutting or pulverizing and granulating the mixture discharged in step 2. If the mixture is hard enough to be pulverized only by shear stress at room temperature, the mixture can be pulverized and granulated by passing through two rollers or the like. The size and shape of the granules obtained in step 3 can be adjusted to some extent by controlling the dimensions of the mixture discharged in step 2 and the gap between the rollers. In the present invention, there is no limitation on the average particle size of the granular molded product, but from the viewpoint of handleability during tablet molding, which will be described later, the average particle size is preferably in a range of 0.05 to 10.0 mm. Furthermore, if the mixture cannot be pulverized by rolling or the like, the mixture can be discharged as a rod-shaped mixture in step 2 and cut to a prescribed size by a rotary cutter or the like while cooling to obtain granules.

The granular curable silicone composition obtained by the manufacturing method of the present invention has excellent flowability during hot-melting and is highly compositionally homogenized, making the composition less prone to non-homogeneity and physical migration of the composition during molding such as compression molding, press molding, lamination, and the like. Thus, there is an advantage where it is easy to homogenously form the entire composition, which is applicable even in a molding step in which shear pressure is not generated. In addition, excellent mold removability in the molding step and strong adhesion to the substrate are achieved by using component (C) and preferably component (D) in combination. Note that the advantages above are not lost even if the granular composition is secondary molded, and thus the granular curable silicone composition may be used as tablets or pellets for transfer molding by compressing or tableting with a tableting machine or the like.

### [Cured Product]

The aforementioned curable silicone composition, particularly a granular (molded) composition or a tablet-molded product thereof, has hot-melt properties, exhibits excellent flowability when molten (hot-melt), handling properties, and curability, and upon curing, forms a cured product suitable for semiconductor members and the like. Depending on the type of curing agent used as component (A2), a variety of heat curing reactions can be selected. However, when component (A2) is selected from thermal radical polymerization initiators such as an organic peroxide or the like and hydrosilylation reaction catalysts or hydrosilylation reaction crosslinking agents, curing by heat curing in a range of 80°C to 200°C is preferred. Note that in the present invention, physical properties such as the linear expansion coefficient, bending strength, and hardness of the cured product can be easily designed to the following suitable ranges based on the type of component (A) and the quantitative range of component (B). Furthermore, even when the curable silicone composition of the present invention contains a large amount of component (B), the combined use of component (C), and preferably component (D), improves the mechanical strength of the resulting cured product, and also provides excellent mold removability during the molding process, as well as strong adhesion to the substrate.

### [Linear Expansion Coefficient of Cured Product]

The cured product obtained by curing the composition has an average linear expansion coefficient of 30 ppm/°C or lower, and preferably 20 ppm/°C or lower, within a range of 25°C to 200°C. Within this range, the difference in average linear expansion coefficient between the cured product and the substrate used is low. Therefore, the residual stress in the obtained integrated molded product can be reduced, improving the reliability of a device.

### [Bending Strength of Cured Product]

Furthermore, it is suitable as a sealing material for a semiconductor which is required to have high hardness and high strength, and therefore, the bending strength of the cured product measured by the method specified in JIS K 6911-1995 "General Testing Method for Thermosetting Plastics" is preferably 15 MPa or more, or 20 MPa or more.

### [Hardness of Cured Product]

It is suitable as a protective member for a semiconductor or the like, and therefore, the cured product obtained by curing the present composition preferably has a type-D durometer hardness of 20 or more at 25°C. Note that this type-D durometer hardness is determined by the type-D durometer in accordance with the JIS K 6253-1997 "Hardness Testing Methods for Vulcanized Rubber and Thermoplastic Rubber".

### [Method for Molding Cured Product]

The present composition (including the granular composition and pellet-shaped molded product or tablet-shaped molded product, which are tableted molded products thereof; the same applies hereinafter) can be cured by a method including at least the following steps (I) to (III):
(I) Step of heating the present composition to a temperature of 100°C or higher to melt the composition;
(II) Step of injecting the curable silicone composition obtained in the aforementioned step (I) into a metal die or step of distributing the curable silicone composition obtained in the aforementioned step (I) to a metal die by clamping; and
(III) Step of curing the curable silicone composition injected in the aforementioned step (II).

The present composition exhibits relatively low melt viscosity at a temperature of 100°C or higher, and thus has excellent hot-melt properties, flowability, and gap-filling properties under pressure, making it suitable for use in molding methods that include a coating step (so-called mold underfill method) in which a semiconductor element is overmolded and underfilled at a time.

Furthermore, based on the properties described above, the present composition can be suitably used in a molding method including a coating step (so-called wafer molding) in which the surface of a semiconductor substrate (including wafer substrates) on which a single or a plurality of semiconductor elements are mounted is covered and overmolded such that gaps between the semiconductor elements are filled with the cured product. In particular, the composition of the present invention has the advantage that the cured molded product has excellent mold removability and adhesion to substrates.

A transfer molding machine, compression molding machine, injection molding machine, press molding machine, auxiliary ram molding machine, sliding molder, double ram molding machine, molding machine for low-pressure sealing, or the like can be used in the molding step described above.

In step (III) above, the curable silicone composition injected (applied) in step (II) is cured. The curing method varies depending on the type of component (A2), but when component (A2) is selected from organic peroxides and other thermal radical polymerization initiators and hydrosilylation reaction catalysts or hydrosilylation reaction cross-linking agents, curing by heat curing in the range of 80°C to 200°C is preferable. In particular, when an organic peroxide is used as Component (A2), the heating temperature is preferably 150°C or higher or 170°C or higher.

### [Use of composition]

The curable silicone composition of the present invention (particularly including granular (molded) compositions and tablet-shaped molded product or pellet-shaped molded product thereof) has good hot-melt properties, and has excellent flowability, handling, and curing properties when molten (hot-melt), as well as mold removability and adhesion to substrates. As a result, the composition is suitable as a sealant or underfill agent for semiconductors; a sealant or underfill agent for power semiconductors such as SiC or GaN; a sealant or light-reflecting material for optical semiconductors such as light-emitting diodes, photodiodes, phototransistors, and laser diodes; or an adhesive or protective agent for electrical and electronic applications. Furthermore, the present composition has hot-melt properties, making it suitable as a material for transfer molding, compression molding, press molding, or injection molding. In particular, it is suitable for use as a sealing agent for semiconductors that use the mold underfill method or the wafer molding method during molding.

The present composition is suitable as a sealing agent or the like for a semiconductor as described above, and can be partially or entirely used in place of a conventionally known sealing agent, in a step of sealing a semiconductor or the like by an overmolding method, an underfilling method, a mold underfilling method simultaneously performing these, a wafer molding method, or other molding method using a conventionally known sealing agent (including epoxy sealing agents and other non-silicone-based hot-melt sealing agents), to manufacture a semiconductor package, a power semiconductor module, MEMS, a microsensor (fingerprint sensor), or other small integrated device, a coil containing magnetic particles, or other magnetic member, a flexible substrate (stretchable wiring board) for a wearable device or the like, an optical waveguide connected to an electrical wiring board or connector, or other semiconductor/optical member. For example, the curable silicone composition according to the present invention can be partially or entirely used in place of the sealing agents (particularly including silicone elastomer sealing agents, pastes containing a functional filler, and hot-melt sealing agents) described in Japanese Unexamined Patent Application 2021-097123, Japanese Unexamined Patent Application 2021-024945, Japanese Unexamined Patent Application 2020-132771, Japanese Unexamined Patent Application 2020-132750, Japanese Unexamined Patent Application 2020-125399, Japanese Unexamined Patent Application 2020-123670, Japanese Unexamined Patent Application 2020-084094, Japanese Unexamined Patent Application 2020-088055, Japanese Unexamined Patent Application 2019-006905, Japanese Unexamined Patent Application 2018-188494, Japanese Unexamined Patent Application 2017-179185, Japanese Unexamined Patent Application 2020-023643, Japanese Unexamined Patent Application 2020-063459, Japanese Unexamined Patent Application 2020-090634, Japanese Unexamined Patent Application 2020-088055, Japanese Unexamined Patent Application 2020-107767, Japanese Unexamined Patent Application 2021-080411, Japanese Unexamined Patent Application 2021-036013, Japanese Unexamined Patent Application 2020-152844, Japanese Unexamined Patent Application 2020-158684, Japanese Unexamined Patent Application 2021-019031, Japanese Unexamined Patent Application 2021-059741, Japanese Unexamined Patent Application 2020-057775, Japanese Unexamined Patent Application 2021-015985, Japanese Unexamined Patent Application 2015-114390, Japanese Unexamined Patent Application 2016-177106, and the like. Note that, if necessary, technical elements applicable to these sealing agent compositions may be applied to the present invention, and the composition according to the present invention may and is preferably adjusted with respect to the composition thereof, cured product physical properties, melting properties, and the like.

### [Use of cured product]

Although the application of the cured product according to the present invention is not particularly limited, the curable silicone composition according to the present invention (particularly granular-like (molded) compositions, including tablet-shaped molded products and pellet-shaped molded products, which are tableted molded products thereof) has hot-melt properties and excellent moldability, and the resulting cured product has excellent adhesive properties, high modulus of elasticity, and low coefficient of linear expansion. Therefore, the cured product according to the present invention can be suitably used as a member for a semiconductor device, and can be used as a sealing material for a semiconductor element, IC chip, or the like, or as a light reflective material for an optical semiconductor device.

A semiconductor device provided with a member containing the cured product of the present invention is not particularly limited, but is particularly preferably a semiconductor device mounted on a power semiconductor device, an optical semiconductor device, and a flexible semiconductor device that can expand, contract, or deform.

### EXAMPLES

The hot-melt curable silicone composition of the present invention and manufacturing method thereof are described in detail using examples and comparative examples. Note that in the formulas, Me, Ph, and Vi represent a methyl group, a phenyl group, and a vinyl group, respectively. Furthermore, the softening points and melt viscosities of the curable silicone compositions of each example and comparative example were measured by methods below. Furthermore, the curable silicone compositions were heated at 180°C for two hours to prepare cured products, and adhesion to various base materials were measured by a method below. The results are shown in Table 1.

### [Softening Point of Curable Silicone Composition]

The curable silicone composition was molded into cylindrical pellets of φ14 mm x 22 mm. The pellet was placed on a hot plate set at 25°C to 100°C and continuously pressed from above for 10 seconds by a load of 100 grams, and after the load was removed, the amount of deformation of the pellet was measured. The temperature at which the deformation amount in the height direction was 1 mm or more was defined as the softening point.

### [Melt Viscosity]

The melt viscosity of the curable silicone composition at 180 °C was measured using a Koka type flow tester CFT-500EX (manufactured by Shimadzu Corporation) using a 1.0 mm diameter nozzle under a pressure of 100 kgf.

### [Mold removability in molding process]

A cylindrical tablet made of the curable silicone composition was thermally cured in a spiral flow mold at a temperature of 180°C for 3 minutes using a transfer molding machine, and the cured product was then removed from the mold. The mold removability of each cured product was evaluated according to the following criteria. The mold removability was evaluated as extremely good (⊚) when the cured product could be removed from the mold simply by opening the upper and lower molds; good (∘) when the cured product peeled off smoothly without breaking when removed from the mold using tweezers; and poor (×) when the cured product was strongly adhered to the mold and was destroyed when removed from the mold using tweezers.

### [Adhesive strength of cured product]

A curable silicone composition was placed at four locations, each approximately 500 mg, on various substrates of 25 mm x 75 mm. Next, the composition was covered with a 10 mm square glass chip having a thickness of 1 mm, then heated and cured for two hours under thermocompression bonding using a 1 kg plate at a temperature of 180°C. Thereafter, the mixture was cooled to room temperature and the die shear strength was determined using a shear strength measuring device (bond tester SS-100KP, available from Seishin Trading Co., Ltd.)

Main agents containing component (A) of the present invention were prepared by the method indicated in Reference Examples 1.

### [Reference Example 1]

A viscous silicone mixture (L1) was obtained by mixing the following components in a 1 L flask:
Component (A1) 100 g of a resinous organopolysiloxane that is a white solid at 25°C with a melting point of 100°C and expressed by the average unit formula

   (PhSiO_{3/2})_{0.80}(Me₂ViSiO_{1/2})_{0.20}
Component (A3-1) 3.2 g of a diphenylsiloxane blocked at both molecular chain ends with dimethylhydrogensiloxy groups, expressed by

   Formula: HMe₂SiO(Ph₂SiO)SiMe₂H
and having a viscosity of 5 mPa·s (amount of silicon atom-bonded hydrogen atoms = 0.6 mass%), and
Component (3A-2) 28.0 g of branched organopolysiloxane expressed by average unit formula:

   (PhSiO_{3/2})_{0.4}(HMe₂SiO_{1/2})_{0.6}
having two or more silicon atom-bonded hydrogen atoms in one molecule, and having a viscosity of 25 mPa·s (amount of silicon atom-bonded hydrogen atoms = 0.65 mass%).

The components used in the examples and comparative examples are shown below in detail. Note that the units for the amount of each component listed in Table 1 is parts by mass.
(A2-1) 2,5-dimethyl-2,5-di(tert-butylperoxy)hexane (the temperature at which the half-life is 10 hours is 118°C)
(A2-2) a thermoplastic polycarbonate resin containing 4000 ppm of a 1,3-divinyl-1,1,3,3-tetramethyldisiloxane complex of Pt (0 valence) as the platinum amount (softening point = 150°C)
(B-1) Fused silica with an average particle size of 14.5 µm (S6105P manufactured by Nippon Steel Materials Micron, Inc.)
(B-2) Fused silica with an average particle size of 0.7 µm (SPH507M manufactured by Nippon Steel Materials Micron)
(B-3): Denka Black Press product (manufactured by Denka Co., Ltd.)
(B') Dimethyl polysiloxane having the formula:

   Me₂ViSiO(Me₂SiO)₂₉Si(OMe)₃

   with a viscosity of 23 mPas
(C-1) Polyethylene wax having a melting point of 100°C and a melt viscosity of 4300 mPas at 140°C
(C-2) Polyethylene wax having a melting point of 100°C and a melt viscosity of 1000 mPas at 140°C
(C-3) Oxidized polyethylene wax having a melting point of 120°C and a melt viscosity of 1800 mPas at 140°C
(C-4c) Polyethylene wax having a melting point of 135°C and a melt viscosity of 25000 mPas at 140°C Polypropylene wax *For comparative tests
(D-1) Fatty acid ester wax having a melting point of 70°C and a melt viscosity of 10 mPas at 140°C
(D-2) Carnauba wax having a melting point of 80°C and a melt viscosity of 15 mPas at 140°C
(D-3) Fischer-Tropsch wax having a melting point of 80°C and a melt viscosity of 8 mPas at 140°C
(D-4c) Calcium stearate with a melting point of 150°C and no melt viscosity at 140°C *For comparative tests
(D-5c) Zinc stearate having a melting point of 120°C and a melt viscosity of 300 mPas at 140°C *For comparative tests
(E-1) Methyltris-1,1-dimethyl-2-propynyloxysilane (boiling point at atmospheric pressure = 245°C)
(E-2) 1,6-bis[tris(1,1-dimethyl-2-butynoxy)silyl]hexane (boiling point at atmospheric pressure = 300°C or higher)
(F) Bis(trimethoxysilylpropoxymethyl)allylsilatrane

### [Production Examples (Examples 1 to 7, Comparative Examples 1 to 6)]

Component (B), Component (B'), Component (C), and Component (D) were all added at one time to a small grinder and stirred at 100°C for 1 minute, the fused silica was subjected to a surface treatment, and the temperature of the grinder was then returned to 25°C. Next, the liquid silicone mixture (L1) obtained in Reference Example 1, component (E), component (F), and component (A2) were added to a small grinder and stirred at room temperature (25°C) for 1 minute to prepare a uniform granular curable silicone composition.

The resulting curable silicone composition was placed in a kneader mixer set to 100°C and melt-kneaded for 1 minute at a speed of 100 rpm, resulting in a unified composition that was solid at room temperature. An irregular granular curable silicone composition was prepared by pulverizing this solid fraction while cooling to 0°C. The resulting granular composition was compressed into tablets to obtain cylindrical tablets of the curable silicone composition. The properties, details of each component and the amount added are shown in Tables 1 and 2.

**[Table 1]**

| | Example 1 | Example 2 | Example 3 | Example 4 | Example 5 | Example 6 | Example 7 |
|---|---|---|---|---|---|---|---|
| L1 | 86.4 | 86.4 | 86.4 | 86.4 | 86.4 | 86.4 | 86.4 |
| A2-1 | | | | | | | 2 |
| A2-2 | 0.25 | 0.25 | 0.25 | 0.25 | 0.25 | 0.25 | |
| B-1 | 1250.0 | 1250.0 | 1250.0 | 1250.0 | 1250.0 | 1250.0 | 1250.0 |
| B-2 | 150 | 150 | 150 | 150 | 150 | 150 | 150 |
| B-3 | 1.5 | 1.5 | 1.5 | 1.5 | 1.5 | 1.5 | |
| B' | 6.9 | 6.9 | 6.9 | 6.9 | 6.9 | 6.9 | 6.9 |
| C-1 | 4.5 | | | 1.5 | | | 1.5 |
| C-2 | | 4.5 | | | 1.5 | | |
| C-3 | | | 4.5 | | | 1.5 | |
| C-4c | | | | | | | |
| D-1 | | | | 3.0 | | | 3.0 |
| D-2 | | | | | 3.0 | | |
| D-3 | | | | | | 3.0 | |
| D-4c | | | | | | | |
| D-5c | | | | | | | |
| E-1 | 0.05 | | 0.05 | 0.05 | | | |
| E-2 | | 0.05 | | | 0.05 | 0.05 | |
| F | 6.6 | 6.6 | 6.6 | 6.6 | 6.6 | 6.6 | 6.6 |
| Softening temperature [°C] | 90 | 90 | 90 | 85 | 85 | 85 | 85 |
| Melt viscosity @ 180 °C [Pas]. | >100 | 87 | >100 | 17 | 20 | 17 | 21 |
| Mold removability | ○ | ○ | ○ | ○ | ○* | ○ | ○ |
| Adhesive strength to copper [MPa] | 6 | 8 | 5 | 12 | 13 | 12 | 11 |

| | | | | | | | |
|---|---|---|---|---|---|---|---|
| *Improved to ⊚ after three consecutive times (Example 8). | | | | | | | |

**[Table 2]**

| | Comparative example 1 | Comparative example 2 | Comparative example 3 | Comparative example 4 | Comparative example 5 | Comparative example 6 |
|---|---|---|---|---|---|---|
| L1 | 86.4 | 86.4 | 86.4 | 86.4 | 86.4 | 86.4 |
| A2-1 | | | | | | |
| A2-2 | 0.25 | 0.25 | 0.25 | 0.25 | 0.25 | 0.25 |
| B-1 | 1250.0 | 1250.0 | 1250.0 | 1250.0 | 1250.0 | 1250.0 |
| B-2 | 150 | 150 | 150 | 150 | 150 | 150 |
| B-3 | 1.5 | 1.5 | 1.5 | 1.5 | 1.5 | 1.5 |
| B' | 6.9 | 6.9 | 6.9 | 6.9 | 6.9 | 6.9 |
| C-1 | | | | | | |
| C-2 | | | | | | |
| C-3 | | | | | | |
| C-4c | 4.5 | | | | | |
| D-1 | | | | | | 3.0 |
| D-2 | | | | 4.5 | | |
| D-3 | | | | | 4.5 | |
| D-4c | | 4.5 | | | | |
| D-5c | | | 4.5 | | | |
| E-1 | 0.05 | | 0.05 | 0.05 | | |
| E-2 | | 0.05 | | | 0.05 | 0.05 |
| F | 6.6 | 6.6 | 6.6 | 6.6 | 6.6 | 6.6 |
| Softening temperature [°C] | 90 | 85 | 85 | 85 | 85 | 85 |
| Melt viscosity @ 180 °C [Pas]. | >100 | 25 | 22 | 15 | 18 | 14 |
| Mold removability | X | X | ○ | ○ | X | X |
| Adhesive strength to copper [MPa] | 1 | 0 | 0 | 0 | 13 | 11 |

### [Example 8]

The mold removability test for the composition of Example 5 was carried out three times in succession, and the mold removability was improved to ⊚.

### [Example 9: Application to mold coating applications and improvement of mold removability]

A composition was prepared in the same manner as in Example 1 using the same components and added amounts, except that the amount of component (C1) of Example 1 was changed to 30 parts by mass. The resulting cylindrical tablet-shaped curable silicone composition was thermally cured in a spiral flow mold at a temperature of 180°C for 3 minutes using a transfer molding machine, and the cured product was removed from the mold simply by opening the upper and lower dies. Next, the cylindrical tablet-shaped curable silicone composition obtained in Example 5 was molded, and the mold removability was improved to an extremely good level (⊚).

### [Summary]

Examples 1 to 3 of the present invention confirmed that excellent mold removability was achieved due to the inclusion of component (C). On the other hand, component (C) was found to have a limited effect of lowering the melt viscosity of the composition, and therefore the melt viscosity at 180°C was high. On the other hand, in Examples 4 to 7, components (C) and component (D) were used in combination, and these compositions exhibited excellent mold removability while also achieving a low melt viscosity at 180°C. In particular, the compositions of these examples were confirmed to have low melt viscosity, which improves wettability to the substrate, and improved adhesive strength of the cured molded product. Furthermore, the results of Example 8 (where Example 5 was repeated three times) showed that the mold removability of the composition of the present invention was further improved by continuous molding. Furthermore, Example 9 shows an example of using the composition of the present invention for mold coating purposes. In this example, by molding a composition containing a larger amount of component (C), the entire mold was coated with the release component, and when the composition of Example 5 was subsequently molded, excellent mold removability was exhibited from the first molding. By combining these results with the results of Example 8, continuous molding is possible over a long period of time. Note that in all of the examples, the composition of the present invention provided a high amount of the functional inorganic filler (specifically, components B-1 to B-3) that is component (B), and the cured product thereof is expected to provide excellent mechanical strength and the like. The above results confirm that both good mold removability of the cured product during transfer molding and good adhesion to the substrate can be provided by using a thermosetting silicone composition of the present invention that has a high amount of functional inorganic filler, contains the specific polyolefin wax of the present invention, component (C), and preferably also a wax, component (D).

On the other hand, when a wax component having a melting point of 130°C or higher was used in Comparative Examples 1 and 2, no improvement in mold removability was observed, as compared to the Examples. Furthermore, Comparative Examples 3 to 6 do not contain the specific polyolefin wax, component (C). However, it was confirmed that even if a similar thermosetting silicone composition uses only component (D), both mold removability and adhesiveness can be achieved in the absence of component (C).

## Claims

1. A curable silicone composition, comprising:
(A) a thermosetting silicone;
(B) a functional inorganic filler; and
(C) a polyolefin wax having a melting point of 130°C or less and a viscosity at 140°C of 100 mPas or more,
wherein
the amount of component (B) is 40 parts by mass or more per 100 parts by mass of component (A), and the composition as a whole exhibits hot-melt properties.

2. The curable silicone composition according to claim 1, further comprising (D) a wax having a melting point of 130°C or lower and a viscosity at 140°C of less than 100 mPas.

3. The curable silicone composition according to claim 1, wherein component (A) contains at least:
(A1) an organopolysiloxane resin containing at least 20 mol% or more of siloxane units expressed by RSiO_{3/2} (where R represents a monovalent hydrocarbon group) with respect to all siloxane units; and
(A2) a curing agent.

4. The curable silicone composition according to claim 3, wherein component (A2) is a curing agent containing a curing reaction catalyst that becomes active in the composition when stimulated with thermal energy at 80°C or higher.

5. The curable silicone composition according to claim 3, wherein component (A2) contains one or more curing agents selected from:
(A2-1) an organic peroxide with a half-life of 10 hours at a temperature of 80°C or higher; and
(A2-2) hydrosilylation reaction catalyst-containing thermoplastic resin microparticles containing a thermoplastic resin with a softening point or glass transition point of 80°C or higher.

6. The curable silicone composition according to claim 3, wherein at least a portion or all of component (A1) is
(A1-1) a hot-melt organopolysiloxane resin with a softening point of 30 °C or higher, having a curable reactive functional group containing at least one carbon-carbon double bond per molecule, and where at least 20 mol% or more of all siloxane units are siloxane units expressed by RSiO_{3/2} (where R is a monovalent hydrocarbon group).

7. The curable silicone composition according to claim 3, wherein at least a portion or all of component (A1) is
(A1-1-1) a hot-melt organopolysiloxane resin with a softening point of 30 °C or higher and having a curable reactive functional group containing at least one carbon-carbon double bond per molecule, where at least 20 mol% or more of all siloxane units are siloxane units expressed by RSiO_{3/2} (where R is a monovalent hydrocarbon group), and 10 mol% or more of the silicon atom-bonded organic groups are aryl groups.

8. The curable silicone composition according to Claim 1, wherein component (B) is a reinforcing filler, pigment, heat conductive filler, conductive filler, phosphor, magnetic particles, or a mixture of two or more types thereof.

9. The curable silicone composition according to any one of claims 1 to 8, which is in the form of granules.

10. A pellet-shaped molded product or tablet-shaped molded product obtained by compression molding the curable silicone composition according to any one of claims 1 to 9.

11. A cured product obtained by curing the curable silicone composition according to any one of claims 1 to 9, or the pellet-shaped molded product or tablet-shaped molded product according to claim 10.

12. A member for a semiconductor device, comprising the cured product according to claim 11.

13. A semiconductor device comprising the cured product according to claim 11.

14. A method for producing the granular curable silicone composition according to claim 9, comprising:
melting and kneading the curable silicone composition within a temperature range of 50 to 150°C; and
molding to form granules,
the curable silicone composition, containing:
(A) a thermosetting silicone;
(B) a functional inorganic filler; and
(C) a polyolefin wax having a melting point of 130°C or less and a viscosity at 140°C of 100 mPas or more,
where the amount of component (B) is 40 parts by mass or more per 100 parts by mass of component (A).

15. A method for molding the cured product according to claim 11, comprising: at least the following steps (I) to (III):
(I) a step of melting the curable silicone composition according to any one of claims 1 to 9 or the pellet-shaped molded product or tablet-shaped molded product according to claim 10 by heating to 100°C or higher;
(II) a step of injecting the curable silicone composition obtained in the aforementioned step (I) into a metal die or step of distributing the curable silicone composition obtained in the aforementioned step (I) to a metal die by clamping; and
(III) a step of curing the curable silicone composition injected in the aforementioned step (II).

16. The method for molding a cured product according to claim 15, further comprising a coating step in which overmolding and underfilling of a semiconductor element are performed once using a cured product obtained by curing the curable silicone composition according to any one of claims 1 to 10 or the pellet-shaped molded product or tablet-shaped molded product according to claim 11.

17. The method for molding a cured product according to claim 15, further comprising a coating step of coating a surface of a semiconductor substrate on which one or a plurality of semiconductor elements are mounted with a cured product obtained by curing the curable silicone composition according to any one of claims 1 to 9 or the pellet-shaped molded product or tablet-shaped molded product according to claim 10, and then overmolding such that gaps in the semiconductor element are filled with the cured product.
